# EUROPEAN PATENT APPLICATION

(11) **EP 4 425 538 A1**
(43) Date of publication of application: **04.09.2024**
(21) Application number: 24155021.9
(22) Date of filing: 31.01.2024
(51) Int. Cl.: H01L 21/78, H01L 21/822, H01L 25/065, H01L 23/48

(54) **METHOD OF MANUFACTURING SEMICONDUCTOR DEVICE**

(30) Priority: 01.03.2023 JP 2023031379
(71) Applicant: Kioxia Corporation, Tokyo 108-0023 (JP)
(72) Inventor: Noda, Mitsuhiko, Tokyo, 108-0023 (JP); Kashiwada, Saori, Tokyo, 108-0023 (JP)
(74) Representative: Hoffmann Eitle

(57) **Abstract**

According to one embodiment, a method of manufacturing a semiconductor device includes: forming a laser peeling film above a first semiconductor substrate; forming a circuit layer above the laser peeling film; bonding the first semiconductor substrate and a second semiconductor substrate; applying a laser beam to a back surface of the first semiconductor substrate; and peeling the first semiconductor substrate to maintain the circuit layer on a side of the second semiconductor substrate. Forming the laser peeling film includes forming, inside the laser peeling film, a thermal diffusion layer. The thermal diffusion layer includes a member having a coefficient of thermal conductivity higher than that of the laser peeling film.

## Description

### CROSS-REFERENCE TO RELATED APPLICATION

This application is based upon and claims the benefit of priority from Japanese Patent Application No. 2023-031379, filed March 1, 2023.

### FIELD

Embodiments described herein relate generally to a semiconductor device and a method of manufacturing the semiconductor device.

### BACKGROUND

A three-dimensional layer stacking technique has been known, with which semiconductor circuit substrates are three-dimensionally stacked.

### BRIEF DESCRIPTION OF THE DRAWING(S)

FIG. 1 is a schematic view showing an outline of a reuse process for a semiconductor substrate.
FIG. 2 is a schematic view showing an example of a configuration of a semiconductor device having a bonded structure.
FIG. 3 is a block diagram showing an example of an overall configuration of a semiconductor device according to a first embodiment.
FIG. 4 is a circuit diagram showing an example of a circuit configuration of a memory cell array included in the semiconductor device according to the first embodiment.
FIG. 5 is a perspective view showing an example of an appearance of the semiconductor device according to the first embodiment.
FIG. 6 is a plan view showing an example of a planar layout of the memory cell array included in the semiconductor device according to the first embodiment.
FIG. 7 is a plan view showing an example of a planar layout of a memory region of the memory cell array included in the semiconductor device according to the first embodiment.
FIG. 8 is a cross-sectional view taken along line VIII-VIII of FIG. 7 and showing an example of a cross-sectional structure of a first wafer before bonding, in the semiconductor device according to the first embodiment.
FIG. 9 is a cross-sectional view taken along line IX-IX of FIG. 8 and showing an example of a cross-sectional structure of a memory pillar in the semiconductor device according to the first embodiment.
FIG. 10 is a plan view showing an example of a planar layout of a peeling layer included in the first wafer before bonding, in the semiconductor device according to the first embodiment.
FIG. 11 is a cross-sectional view showing an example of a cross-sectional structure of the semiconductor device according to the first embodiment.
FIG. 12 is a flowchart showing an example of a method of manufacturing the semiconductor device according to the first embodiment.
FIG. 13 is a cross-sectional view showing an example of a cross-sectional structure halfway through the manufacturing of the semiconductor device according to the first embodiment.
FIG. 14 is a cross-sectional view showing an example of a cross-sectional structure halfway through the manufacturing of the semiconductor device according to the first embodiment.
FIG. 15 is a plan view showing an example of a planar layout of a peeling layer according to a first modification.
FIG. 16 is a plan view showing an example of a planar layout of a peeling layer according to a second modification.
FIG. 17 is a cross-sectional view showing an example of a cross-sectional structure of a first wafer before bonding, in a semiconductor device according to a second embodiment.
FIG. 18 is a cross-sectional view showing an example of a cross-sectional structure of the semiconductor device according to the second embodiment.
FIG. 19 is a flowchart showing an example of a method of manufacturing the semiconductor device according to the second embodiment.
FIG. 20 is a cross-sectional view showing an example of a cross-sectional structure halfway through the manufacturing of the semiconductor device according to the second embodiment.
FIG. 21 is a cross-sectional view showing an example of a cross-sectional structure halfway through the manufacturing of the semiconductor device according to the second embodiment.
FIG. 22 is a cross-sectional view showing an example of a cross-sectional structure of a first wafer before bonding, in a semiconductor device according to a third embodiment.
FIG. 23 is a cross-sectional view showing an example of a cross-sectional structure of the semiconductor device according to the third embodiment.
FIG. 24 is a flowchart showing an example of a method of manufacturing the semiconductor device according to the third embodiment.
FIG. 25 is a cross-sectional view showing an example of a cross-sectional structure halfway through the manufacturing of the semiconductor device according to the third embodiment.
FIG. 26 is a cross-sectional view showing an example of a cross-sectional structure halfway through the manufacturing of the semiconductor device according to the third embodiment.
FIG. 27 is a cross-sectional view showing an example of a cross-sectional structure of a first wafer before bonding, in the semiconductor device according to the first embodiment.
FIG. 28 is a cross-sectional view showing an example of a detailed cross-sectional structure of a bonded portion of a bonding pad.

### DETAILED DESCRIPTION

In general, according to one embodiment, a method of manufacturing a semiconductor device includes: forming a laser peeling film above a first semiconductor substrate (W1); forming a circuit layer including a semiconductor circuit above the laser peeling film; after forming the circuit layer, bonding the first semiconductor substrate and a second semiconductor substrate; after bonding the first semiconductor substrate and the second semiconductor substrate, applying a laser beam to a back surface of the first semiconductor substrate; and after applying the laser beam to the back surface of the first semiconductor substrate, peeling the first semiconductor substrate to maintain the circuit layer on a side of the second semiconductor substrate. Forming the laser peeling film includes forming, inside the laser peeling film, a thermal diffusion layer distributed in a plane parallel to a front surface of the first semiconductor substrate. The thermal diffusion layer includes a member having a coefficient of thermal conductivity higher than that of the laser peeling film.

Hereinafter, embodiments will be described with reference to the accompanying drawings. Each embodiment illustrates a device and a method for embodying the technical idea of the invention. The drawings are schematic or conceptual. The dimensions, scales, etc. used in the drawings are not necessarily the same as those of the actual products. Parts of the configurations may be suitably omitted. The hatching applied in the planar views does not necessarily relate to the material or characteristics of the hatched components. Throughout the specification, structural components having basically the same functions and configurations are referred to by the same reference symbols. The reference symbols may contain numerals or character strings to distinguish similar components having the same reference symbols from each other.

### <0> Outline of Wafer Reuse Process

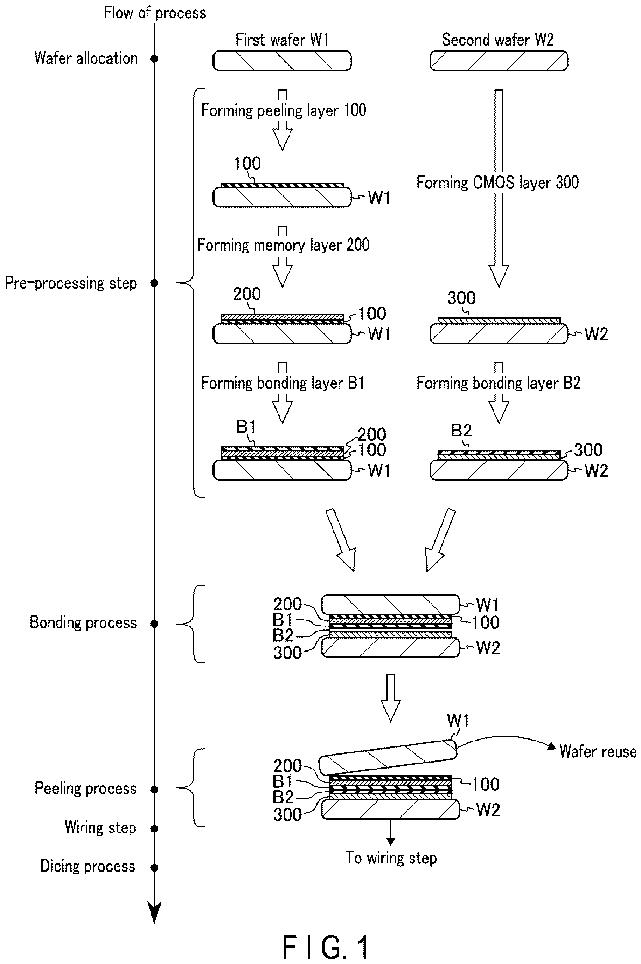

First, an outline of a wafer reuse process will be explained. FIG. 1 is a schematic view showing an outline of a wafer reuse process. As shown in FIG. 1, a semiconductor device in this specification is formed by bonding two semiconductor circuit substrates, each having a semiconductor circuit formed thereon, and by separating the bonded semiconductor circuit substrate into chips. Hereinafter, a semiconductor circuit substrate will be referred to as a "wafer". A process of bonding two wafers will be referred to as a "bonding process". A "front surface of a wafer" corresponds to a surface of the wafer that is on a side on which the semiconductor circuit is formed. A "back surface of a wafer" corresponds to a surface opposite to the front surface of the wafer. A wafer arranged on an upper side during the bonding process will be referred to as a "first wafer W1". A wafer arranged on a lower side during the bonding process will be referred to as a "second wafer W2".

In a process of manufacturing a semiconductor device, first, a pair of a first wafer W1 and a second wafer W2 are prepared ("wafer allocation"). Each of the first wafer W1 and the second wafer W2 is a silicon substrate. In this embodiment, the first wafer W1 is used to form a memory cell array including memory cells capable of storing data in a nonvolatile manner. The second wafer W2 is used to form a CMOS circuit capable of controlling the memory cell array formed on the first wafer W1. The design of the circuit formed on the first wafer W1 and the design of the circuit formed on the second wafer W2 can be changed appropriately.

Next, a pre-processing step for each of the first wafer W1 and the second wafer W2 is executed, and a semiconductor circuit is formed on each of the first wafer W1 and the second wafer W2. Before forming a first semiconductor circuit, a layer for realizing a wafer reuse process is formed. Specifically, a peeling layer 100, a memory layer 200, and a bonding layer B1 are formed on the first wafer W1 in this order. The peeling layer 100 is used as a starting point of separating the first wafer W1 and the circuit formed on the first wafer W1 from each other. The peeling layer 100 contains a material having a characteristic of absorbing a laser beam used in a peeling process described later (for example, a silicon oxide film). The memory layer 200 includes a memory cell array. The bonding layer B1 includes a bonding pad for use in connection to the circuit formed on the second wafer W2. On the second wafer W2, a CMOS layer 300 and a bonding layer B2 are formed in this order. The CMOS layer 300 includes a circuit for use in controlling the memory cell array. The bonding layer B2 includes a bonding pad for use in connection to the circuit formed on the first wafer W1.

Next, a bonding process of bonding the first wafer W1 and the second wafer W2 is executed. Specifically, a bonding apparatus arranges a front surface of the first wafer W1 and a front surface of the second wafer W2 face to face. Then, the bonding apparatus adjusts an overlapping position of a pattern formed on the front surface of the first wafer W1 and a pattern formed on the front surface of the second wafer W2, and bonds the front surfaces of the first wafer W1 and the second wafer W2 together. As a result, the bonding layer B1 of the first wafer W1 and the bonding layer B2 of the second wafer W2 are bonded together, and the semiconductor circuit provided on the first wafer W1 and the semiconductor circuit provided on the second wafer W2 are electrically coupled.

Next, a peeling process for the first wafer W1 is executed. In the peeling process in this specification, a peeling method utilizing a laser beam is used. Specifically, first, a laser beam is applied to the back surface of the first wafer W1. Then, a crack is produced at a peripheral portion between the first wafer W1 and the second wafer W2 which have been bonded together. This causes the first wafer W1 to peel off using the peeling layer 100 as the starting point. As a result, a structure in which the CMOS layer 300, the bonding layer B2, the bonding layer B1, and the memory layer 200 are stacked in this order remains on the second wafer W2. The peeled-off first wafer W1 is subjected to a surface treatment, such as removal of residual film, and is thereafter reused ("wafer reuse").

Thereafter, a wiring step is executed for the second wafer W2. The wiring step includes, for example, a step of forming a pad for use in connection to a CMOS circuit formed on the first wafer W1 and an external device, a step of forming a pad for supplying the semiconductor device with power, etc. After the wiring step is completed, the second wafer W2 is separated into chip units by a dicing process. As a result, the semiconductor device having a bonded structure is formed. The specification describes an example in which the semiconductor device is formed utilizing two wafers, but the semiconductor device is not limited to this example. The number of wafers used to form the semiconductor device may be three or more. That is, the semiconductor device may have a bonded structure utilizing a total of three or more wafers. The peeling layer 100 may be referred to as a "laser peeling film". The laser peeling film is a film that absorbs a laser applied thereto by laser radiation and causes peeling at an interface between the laser peeling film and the semiconductor substrate (wafer).

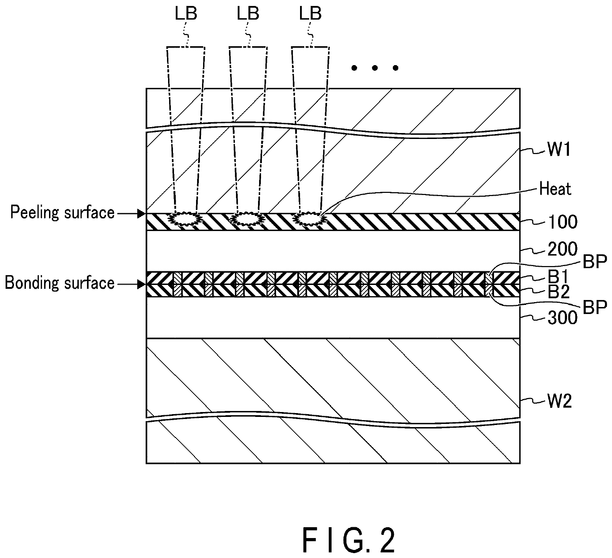

FIG. 2 is a schematic view showing an example of a configuration of a semiconductor device 1 having a bonded structure. FIG. 2 also shows a state in which laser beams are applied to the back surface of the first wafer W1 in the peeling process for the first wafer W1. As shown in FIG. 2, each of the bonding layers B1 and B2 includes a plurality of bonding pads BP. Each bonding pad BP in the bonding layer B1 is coupled to a semiconductor circuit (not shown) formed in the memory layer 200. Each bonding pad BP in the bonding layer B2 is coupled to a semiconductor circuit (not shown) formed in the CMOS layer 300. The bonding pads BP in the bonding layer B1 are respectively arranged to face the bonding pads BP in the bonding layer B2. The paired bonding pads BP arranged to face each other are bonded together by the bonding process and electrically coupled.

In the peeling process for the first wafer W1, the laser beams LB are applied to the back surface of the first wafer W1 at predetermined intervals. As the laser beam LB, for example, a CO₂ laser of a wavelength of, for example, 9.2 to 10.8 µm is used. The CO₂ laser has the characteristics of being transmitted through a silicon substrate and being absorbed by a silicon oxide film. In other words, the transmittance of the first wafer W1 with respect to the laser beam LB is higher than the transmittance of a silicon oxide film with respect to the laser beam LB. Therefore, when the laser beam LB applied to the back surface of the first wafer W1 is transmitted through the first wafer W1 and is applied to the silicon oxide film included in the peeling layer 100, the silicon oxide film is heated by radiation of the laser beam LB. The heat generated in the peeling layer 100 propagates to a portion near an interface between the first wafer W1 and the peeling layer 100. As a result, the portion of the first wafer W1 that is near the interface with the peeling layer 100 is plastically deformed in accordance with the propagated heat. The interface between the plastically deformed first wafer W1 and the peeling layer 100 can be more easily peeled off than before the laser beam is applied. Accordingly, in the peeling process, the first wafer W1 can be peeled off from the peeling layer 100 at a peeling surface between the first wafer W1 and the peeling layer 100.

### <1> First Embodiment

The first embodiment relates to a configuration and a manufacturing method of the semiconductor device 1 that can suppress, using a pattern provided on the peeling layer 100, degradation of device characteristics of a semiconductor circuit due to a peeling process which allows reuse of a wafer. The first embodiment will be described below.

### <1-1> Configuration

First, the configuration of the semiconductor device 1 according to the first embodiment will be described. The semiconductor device 1 according to the first embodiment is, for example, a NAND-type flash memory capable of storing data in a nonvolatile manner. In the following, a case will be described in which the semiconductor device 1 is a memory device, such as a NAND-type flash memory.

### <1-1-1> Overall Configuration of Semiconductor Device 1

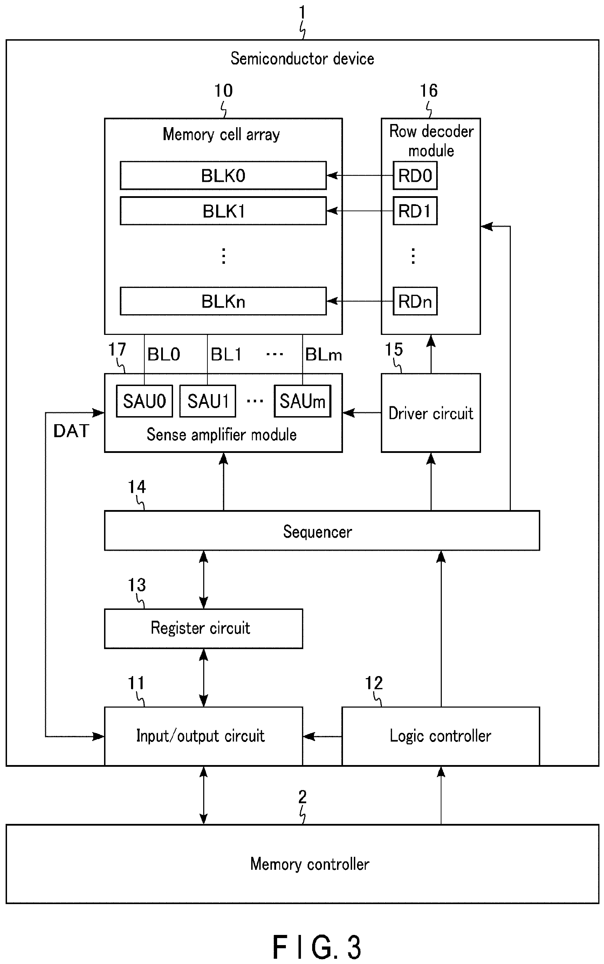

FIG. 3 is a block diagram showing an example of an overall configuration of the semiconductor device 1 according to the first embodiment. As shown in FIG. 3, the semiconductor device 1 is controlled by an external memory controller 2. The semiconductor device 1 includes, for example, a memory cell array 10, an input/output circuit 11, a logic controller 12, a register circuit 13, a sequencer 14, a driver circuit 15, a row decoder module 16, and a sense amplifier module 17.

The memory cell array 10 includes a plurality of blocks BLK0 through BLKn ("n" is an integer equal to or greater than 1). A block BLK is a set of a plurality of memory cells. The block BLK corresponds to a data erasure unit, for example. The block BLK includes a plurality of pages. A page corresponds to a unit for which data reading and data writing are executed. Although not shown in the drawings, the memory cell array 10 is provided with a plurality of bit lines BL0 through BLm ("m" is an integer equal to or larger than 1) and a plurality of word lines WL. Each memory cell is associated with one bit line BL and one word line WL.

The input/output circuit 11 is an interface circuit that controls the transmission and reception of input/output signals transmitted to/from the memory controller 2. The input/output signals include, for example, data DAT, status information, address information, commands, and the like. The input/output circuit 11 can input/output the data DAT to/from the sense amplifier module 17 and to/from the memory controller 2. The input/output circuit 11 can output the status information transferred from the register circuit 13 to the memory controller 2. The input/output circuit 11 can output each of the address information and the command, which are transferred from the memory controller 2, to the register circuit 13.

The logic controller 12 controls each of the input/output circuit 11 and the sequencer 14 based on a control signal input from the memory controller 2. For example, the logic controller 12 controls the sequencer 14 and enables the semiconductor device 1. The logic controller 12 reports to the input/output circuit 11 that the input/output signal received by the input/output circuit 11 is a command, address information, or the like. The logic controller 12 instructs the input/output circuit 11 to input/output an input/output signal.

The register circuit 13 temporarily stores the status information, the address information, and the command. The status information is updated under the control of the sequencer 14, and is transferred to the input/output circuit 11. The address information includes a block address, a page address, a column address, and the like. The command includes instructions related to various operations of the semiconductor device 1.

The sequencer 14 controls the overall operation of the semiconductor device 1. The sequencer 14 executes a read operation, a write operation, an erase operation, and the like, based on the command and the address information stored in the register circuit 13.

The driver circuit 15 generates voltages used in a read operation, a write operation, an erase operation, and the like. The driver circuit 15 supplies the generated voltages to the row decoder module 16, the sense amplifier module 17, and the like.

The row decoder module 16 is a circuit for use in selecting a block BLK to be operated, and transferring a voltage to interconnects, such as the word lines WL. The row decoder module 16 includes a plurality of row decoders RD0 through RDn. The row decoders RD0 through RDn are respectively associated with block BLK0 through BLKn. Each row decoder RD is used to select a block BLK.

The sense amplifier module 17 is a circuit for use in transferring a voltage to each bit line BL and reading data. The sense amplifier module 17 includes a plurality of sense amplifier units SAU0 through SAUm. The sense amplifier units SAU0 through SAUm are respectively associated with the bit lines BL0 through BLm. Each sense amplifier unit SAU includes a sense amplifier for determining data and a latch circuit for temporarily holding data.

A combination of the semiconductor memory device 1 and the memory controller 2 may constitute a single semiconductor device. Examples of such semiconductor devices include a memory card such as a SD^{™} card, a solid state drive (SSD), etc.

### <1-1-2> Circuit Configuration of Memory Cell Array 10

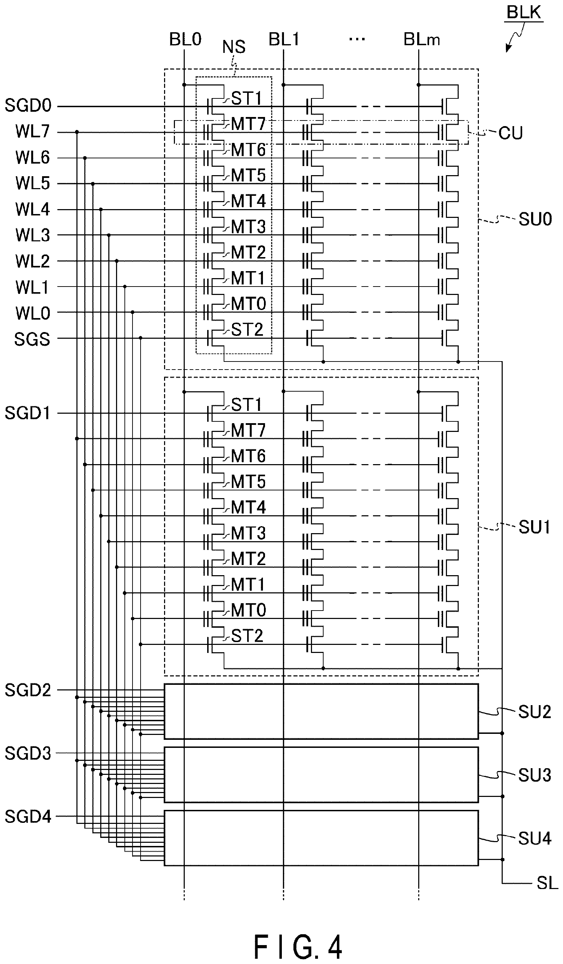

FIG. 4 is a circuit diagram showing an example of a circuit configuration of the memory cell array 10 included in the semiconductor device 1 of the first embodiment. FIG. 4 shows one block BLK among a plurality of blocks BLK included in the memory cell array 10. As shown in FIG. 4, the block BLK includes, for example, five string units SU0 through SU4. Each of select gate lines SGD0 through SGD4 and SGS and word lines WL0 through WL7 is provided for each block BLK. The bit lines BLO through BLm and the source line SL are shared by the blocks BLK.

Each string unit SU includes a plurality of NAND strings NS. The NAND strings NS are respectively associated with the bit lines BLO through BLm. In other words, each bit line BL is shared by the NAND strings NS to which the same column address is assigned from among a plurality of blocks BLK. Each NAND string NS is coupled between the associated bit line BL and source line SL. Each NAND string NS includes, for example, memory cell transistors MT0 through MT7 and select transistors ST1 and ST2. Each memory cell transistor MT is a memory cell including a control gate and a charge storage layer, and holds (stores) data in a nonvolatile manner. Each of the select transistors ST1 and ST2 is used to select a string unit SU.

In each NAND string NS, the select transistor ST1, the memory cell transistors MT7 through MT0, and the select transistor ST2 are coupled in series in this order. Specifically, the drain and the source of the select transistor ST1 are respectively coupled to the associated bit line BL and the drain of the memory cell transistor MT7. The drain and the source of the select transistor ST2 are respectively coupled to the source of the memory cell transistor MT0 and the source line SL. The memory cell transistors MT0 through MT7 are coupled in series between the select transistors ST1 and ST2.

The select gate lines SGD0 through SGD4 are respectively associated with the string units SU0 through SU4. Each select gate line SGD is coupled to respective gates of a plurality of select transistors ST1 included in the associated string unit SU. The select gate line SGS is coupled to respective gates of a plurality of select transistors ST2 included in the associated blocks BLK. The word lines WL0 through WL7 are respectively coupled to the memory cell transistors MT0 through MT7.

A set of memory cell transistors MT coupled to a common word line WL in the same string unit SU is referred to as, for example, a "cell unit CU". For example, the storage capacity of the cell unit CU in a case where each memory cell transistor MT stores 1-bit data is defined as "1-page data". The cell unit CU can have a storage capacity of 2-page data or more in accordance with the number of bits of data to be stored in each memory cell transistor MT.

The memory cell array 10 in the semiconductor device 1 according to the first embodiment may have another circuit configuration. For example, the number of string units SU included in each block BLK or the number of each of the memory cell transistors MT and the select transistors ST1 and ST2 included in each NAND string NS may be designed to be any number.

### <1-1-3> Structure of Semiconductor Memory Device 1

An example of a structure of the semiconductor device 1 according to the first embodiment will be described below. A three-dimensional Cartesian coordinate system is used in the drawings that will be referred to below. An X direction and a Y direction are directions intersecting with each other and parallel to the surface of the wafer. The X direction corresponds to the extending direction of the word line WL. The Y direction corresponds to the extending direction of the bit line BL. A Z direction is a direction intersecting both of the X direction and the Y direction and corresponds to a direction vertical to a surface of a substrate. In this specification, "up" and "down" are defined based on the Z direction. Furthermore, in this specification, the direction away from the front surface of the substrate as a reference is defined as a positive direction (upward).

### (1: Appearance of Semiconductor Device 1)

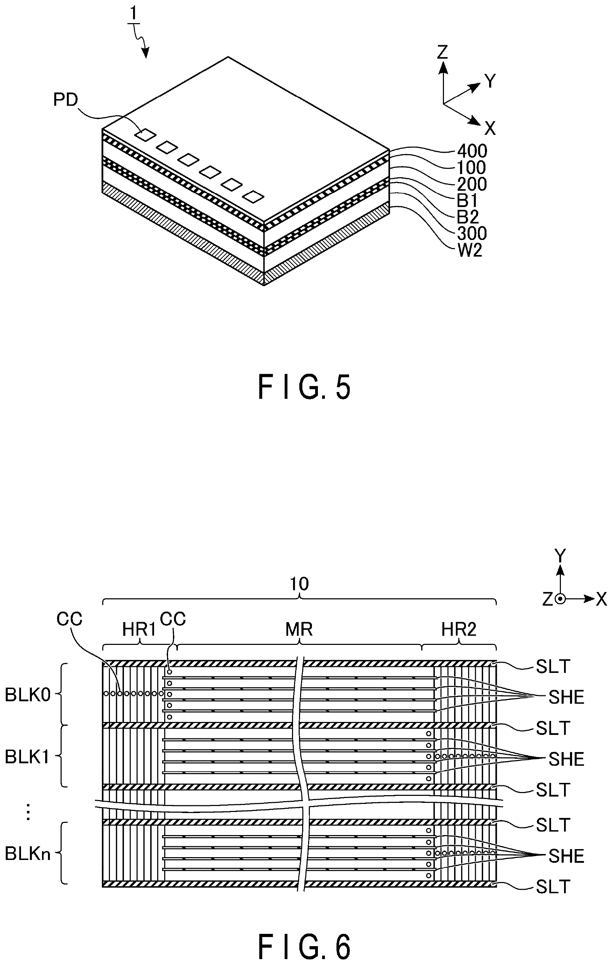

FIG. 5 is a perspective view showing an example of an appearance of the semiconductor device 1 according to the first embodiment. As shown in FIG. 5, the semiconductor device 1 has a structure in which, for example, the second wafer W2, the CMOS layer 300, the bonding layer B2, the bonding layer B1, the memory layer 200, the peeling layer 100, and an interconnect layer 400 are stacked in this order from below.

The CMOS layer 300 includes, for example, an input/output circuit 11, a logic controller 12, a register circuit 13, a sequencer 14, a driver circuit 15, a row decoder module 16, and a sense amplifier module 17. A boundary between the bonding layer B1 and the bonding layer B2 corresponds to a bonded surface of the first wafer W1 and the second wafer W2. The memory layer 200 includes the memory cell array 10. The interconnect layer 400 includes a plurality of pads PD exposed on the surface of the semiconductor device 1. The pads PD are used to couple the semiconductor device 1 and the memory controller 2. Depending on the manufacturing steps of the semiconductor device 1, the peeling layer 100 does not necessarily remain as a final configuration of the semiconductor device 1.

### (2: Planar Layout of Memory Cell Array 10)

FIG. 6 is a plan view showing an example of a planar layout of the memory cell array 10 included in the semiconductor device 1 according to the first embodiment. As shown in FIG. 6, the memory cell array 10 includes, for example, a memory region MR and hookup regions HR1 and HR2. The memory region MR includes the plurality of NAND strings NS. The memory region MR is sandwiched by the hookup regions HR1 and HR2 in the X direction. Each of the hookup regions HR1 and HR2 is a region for use in connection between stacked interconnects (for example, the word lines WL and the select gate lines SGD and SGS) and the row decoder module 16. The memory cell array 10 includes a plurality of slits SLT, a plurality of slits SHE, and a plurality of contacts CC.

Each slit SLT has a portion extending in the X direction, and intersects the hookup region HR1, the memory region MR, and the hookup region HR2 along the X direction. The slits SLT are arranged in the Y direction. Each slit SLT divides interconnects (e.g., the word lines WL0 through WL7 and the select gate lines SGD and SGS) that are adjacent to each other via the slit SLT. Each slit SLT may be provided with a conductor having an insulator spacer on a side wall insulated from the interconnects. Alternatively, an insulator may be embedded into each slit SLT. In the memory cell array 10, each of the regions sectioned by the slits SLT in the Y direction corresponds to one block BLK.

Each slit SHE includes a portion extending in the X direction, and extends across the memory region MR along the X direction. A plurality of slits SHE are arranged in the Y direction. In the present example, four slits SHE are arranged between two slits SLT that are adjacent to each other in the Y direction. Each slit SHE has a structure into which an insulator is embedded, for example. Each slit SHE divides interconnects that are adjacent to each other via the slit SHE. It suffices that the slit SHE divides at least the select gate line SGD. In the memory cell array 10, each of the regions sectioned along the Y direction by the slits SLT and SHE corresponds to one string unit SU.

In the hookup regions HR1 and HR2, an end portion of each of the stacked interconnects (for example, the select gate line SGS, the word lines WL0 through WL7, and the select gate line SGD) in the memory cell array 10 includes a terraced portion. The terraced portion corresponds to a portion not overlapping an interconnect layer (conductive layer) provided in the bit line BL side. A structure formed by a plurality of terraced portions is similar to a step, a terrace, a rimstone, etc. In this example, a staircase structure having a level difference in the X direction is formed by an end portion of the select gate line SGS, end portions of the word lines WL0 through WL7, and an end portion of the select gate line SGD.

The contacts CC coupled to the stacked interconnect are coupled to a terraced portion of at least either the hookup region HR1 or HR2. For example, the stacked interconnect in an even-numbered block BLK (BLK0, BLK2, ...) is coupled to the contacts CC provided in the hookup region HR1. The stacked interconnect in an odd-numbered block BLK (BLK1, BLK3, ...) is coupled to the contacts CC provided in the hookup region HR2. The semiconductor device 1 may have a structure in which each hookup region HR has no terraced portion. In this case, the contacts CC coupled to the interconnect layer having a stacked interconnect are provided to penetrate and be separated (insulated) from the upper conductive layers. The hookup region HR may be arranged in such a manner as to separate the memory region MR in the X direction.

The memory cell array 10 in the semiconductor device 1 according to the first embodiment may have another planar layout. For example, the number of slits SHE arranged between two adjacent slits SLT can be designed to be any number. The number of string units SU included in each block BLK can be changed based on the number of slits SHE arranged between two adjacent slits SLT. The arrangement of the contacts CC coupled to the stacked interconnect may be changed appropriately.

### (3: Planar Layout of Memory Region MR)

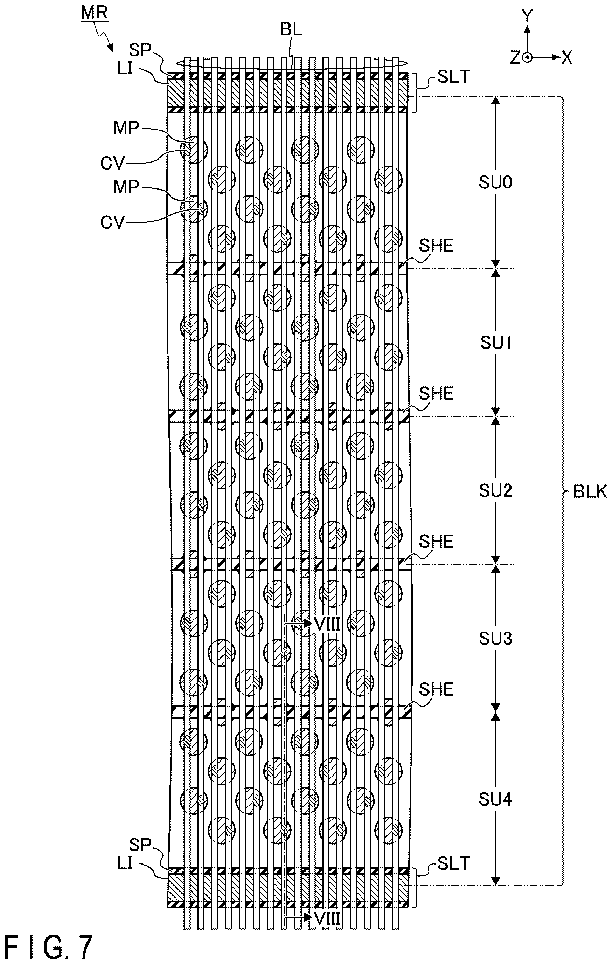

FIG. 7 is a plan view showing an example of a planar layout of the memory region MR of the memory cell array 10 included in the semiconductor device 1 according to the first embodiment. FIG. 7 shows a region including one block BLK (i.e., string units SU0 through SU4). As shown in FIG. 7, in the memory region MR, the memory cell array 10 includes, for example, a plurality of memory pillars MP, a plurality of contacts CV, and a plurality of bit lines BL. Each slit SLT includes a contact LI and a spacer SP.

Each memory pillar MP functions as a single NAND string NS. A plurality of memory pillars MP are in, for example, a 24-row staggered arrangement in an area between two adjacent slits SLT. In this example, a single slit SHE is arranged to overlap each set of the memory pillars MP in the fifth row, the tenth row, the fifteenth row, and the twentieth row, counting from the upper side of the drawing.

Each bit line BL includes a portion that extends in the Y direction. The plurality of bit lines BL are arranged in the X direction. Each bit line BL overlap at least one memory pillar MP in each string unit SU. In the present example, two bit lines BL overlap one memory pillar MP. The memory pillar MP is electrically coupled to the corresponding one bit line BL via the contact CV.

The contact LI is a conductor including a portion that extends in the X direction. The spacers SP are insulators provided on the respective side surfaces of the contact LI. The contact LI is sandwiched by the spacers SP. The contact LI and a conductor (e.g., the word lines WL0 through WL7, and the select gate lines SGD and SGS) adjacent to that contact LI in the Y direction are separated and insulated by the spacer SP. The spacer SP is, for example, an oxide film.

### (4: Cross-Sectional Structure of First Wafer W1)

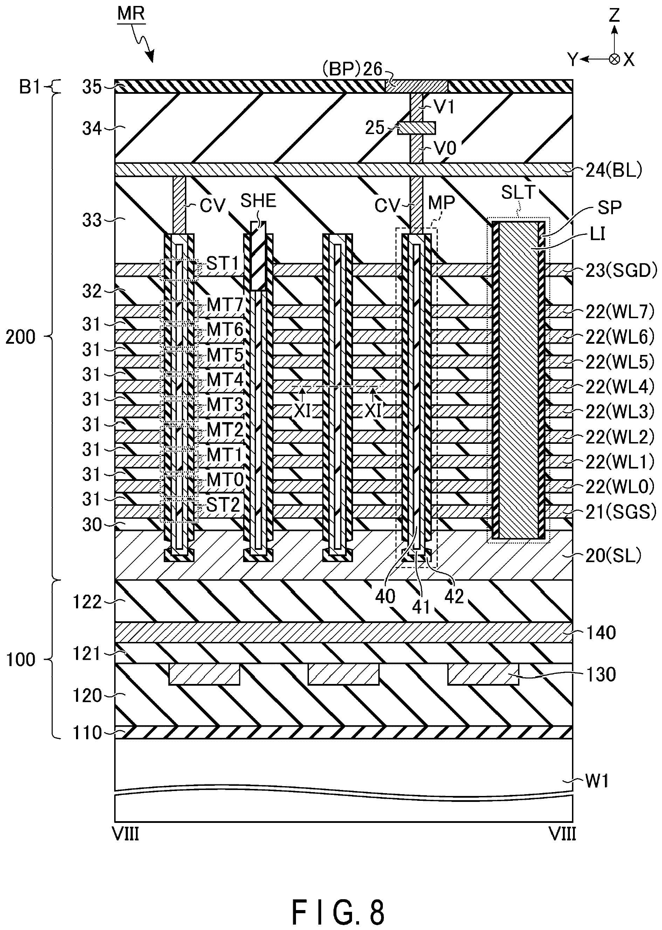

FIG. 8 is a cross-sectional view taken along line VIII-VIII of FIG. 7 and showing an example of a cross-sectional structure of the first wafer W1 before bonding, in the semiconductor device 1 according to the first embodiment. FIG. 8 shows an example of a structure of the memory region MR of the memory cell array 10 formed on the first wafer W1 before being bonded to the second wafer W2, and indicates coordinate axes with respect to the first wafer W1. As shown in FIG. 8, the peeling layer 100 includes a base layer 110, a laser absorbing layer 120, insulating layers 121 and 122, and thermally conductive layers 130 and 140. The memory layer 200 includes, for example, conductive layers 20 through 25, insulating layers 30 through 35, and contacts V0 and V1. The bonding layer B1 includes, for example, a conductive layer 26 and the insulating layer 35.

The base layer 110 is provided on the first wafer W1. The base layer 110 is a film that is easy to plastically deform due to local heating. As the base layer 110, for example, a semiconductor, such as epitaxial silicon, polycrystalline silicon, amorphous silicon, etc., or ceramic material is used. The base layer 110 may be referred to as an "interlayer film".

The laser absorbing layer 120 is provided on the base layer 110. The laser absorbing layer 120 is a film that absorbs a laser used in a peeling process and generates heat. As the laser absorbing layer 120, for example, silicon oxide film may be used. The laser absorbing layer 120 may be referred to as a "light absorbing layer" or an "interlayer film".

The insulating layer 121 is provided above the laser absorbing layer 120. The insulating layer 122 is provided above the insulating layer 121. Each of the insulating layers 121 and 122 may be formed of the same material as, or different material from, that of the laser absorbing layer 120.

A plurality of thermally conductive layers 130 are provided on the laser absorbing layer 120. The thermally conductive layers 130 are arranged in the Y direction. The thermally conductive layers 140 are provided on the insulating layer 121. The thermally conductive layers 140 are arranged in the X direction in an area that is not shown in the drawing. The thermally conductive layers 130 and the thermally conductive layers 140 are separated in the Z direction. Each of the thermally conductive layers 130 and 140 is formed of a material having a light blocking effect and having a coefficient of thermal conductivity higher than that of the laser absorbing layer 120 (for example, silicon oxide film). As each of the thermally conductive layers 130 and 140, metal such as tungsten is used. Each of the thermally conductive layers 130 and 140 may be referred to as a "member". A layer including the thermally conductive layers 130 and 140 may be referred to as a "thermal diffusion layer". In the thermal diffusion layer, members having a coefficient of thermal conductivity higher than that of the laser peeling film and provided within the laser peeling film are distributed in a plane parallel to a surface of the semiconductor substrate.

The conductive layer 20 is provided on the insulating layer 122. The insulating layer 30 is provided on the conductive layer 20. The conductive layer 21 is provided on the insulating layer 30. The insulating layers 31 and conductive layers 22 are alternately stacked on the conductive layer 21. The insulating layer 32 is provided on the uppermost conductive layer 22. The conductive layer 23 is provided on the insulating layer 32. The insulating layer 33 is provided on the conductive layer 23. The conductive layer 24 is provided on the insulating layer 33. The contact V0 is provided on the conductive layer 24. The conductive layer 25 is provided on the contact V0. The contact V1 is provided on the conductive layer 25. The conductive layer 26 is provided on the contact V1. The contact V0, the conductive layer 25, and the contact V1 are covered with the insulating layer 34. The insulating layer 34 may be constituted by a plurality of insulating layers. The insulating layer 35 is provided on the insulating layer 34.

Each of the conductive layers 21, 22, and 23 is, for example, formed in a plate-like shape expanding along an XY plane. The conductive layer 24 is, for example, formed in a linear shape extending in the Y direction. The conductive layers 20, 21, and 23 are used as the source line SL, the select gate line SGS, and the select gate line SGD, respectively. The conductive layers 22 are used as word lines WL0 through WL7, respectively, in order from the lowermost layer. A portion where each memory pillar MP and the conductive layer 21 intersect functions as the select transistor ST2. A portion where each memory pillar MP and the conductive layer 22 intersect functions as the memory cell transistor MT. A portion where each memory pillar MP and the conductive layer 23 intersect functions as the select transistor ST1. The conductive layer 24 is used as the bit line BL. The conductive layers 24 and 25 are coupled via the contact V0. The conductive layers 25 and 26 are coupled via the contact V1. The conductive layer 26 corresponds to the bonding pad BP. The conductive layer 26 contains, for example, copper.

The slit SLT is formed into, for example, a plate-like shape expanding along an XZ plane, and divides the insulating layers 30 through 32 and the conductive layers 21 through 23. The bottom portion of the slit SLT is in contact with the conductive layer 20. The contact LI in the slit SLT is electrically coupled to the conductive layer 20. The spacer SP in the slit SLT separates and insulates the contact LI from each of the conductive layers 21 through 23.

Each memory pillar MP extends in the Z direction, and penetrates the insulating layers 30 through 32 and the conductive layers 21 through 23. Each memory pillar MP includes, for example, a core member 40, a semiconductor layer 41, and a stacked film 42. The core member 40 is an insulator provided to extend in the Z direction. The semiconductor layer 41 surrounds the core member 40. The semiconductor layer 41 is in contact with the conductive layer 20 via a side surface of the memory pillar MP. The stacked film 42 covers a side surface of the semiconductor layer 41, except for a portion in which the semiconductor layer 41 and the conductive layer 20 are in contact with each other. The contact CV is provided on the semiconductor layer 41. The semiconductor layer 41 and the conductive layer 24 are coupled via the contact CV.

### (5: Cross-Sectional Structure of Memory Pillar MP)

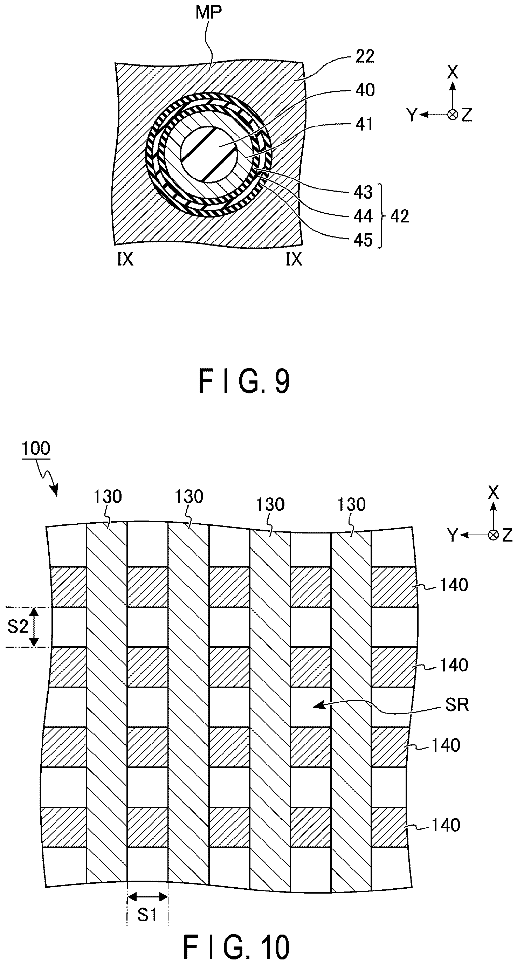

FIG. 9 is a cross-sectional view taken along line IX-IX of FIG. 8 and showing an example of a cross-sectional structure of the memory pillar MP in the semiconductor device 1 according to the first embodiment. FIG. 9 shows a cross section that includes the memory pillar MP and the conductive layer 22 and that is parallel to the surface of the source line SL. As shown in FIG. 9, the stacked film 42 includes a tunnel insulating film 43, an insulating film 44, and a block insulating film 45.

The core member 40 is provided, for example, in a central portion of the memory pillar MP. The semiconductor layer 41 surrounds the side surface of the core member 40. The tunnel insulating film 43 surrounds the side surface of the semiconductor layer 41. The insulating film 44 surrounds the side surface of the tunnel insulating film 43. The block insulating film 45 surrounds the side surface of the insulating film 44. The conductor layer 22 surrounds the side surface of the block insulating film 45. The semiconductor layer 41 is used as a channel (current path) of the memory cell transistors MT0 through MT7 and the select transistors ST1 and ST2. Each of the tunnel insulating film 43 and the block insulating film 45 includes, for example, a silicon oxide film. The insulating film 44 is used as a charge storage layer for the memory cell transistor MT, and includes, for example, silicon nitride film. Accordingly, each memory pillar MP functions as one NAND string NS.

### (6: Planar Layout of Peeling Layer 100)

FIG. 10 is a plan view showing an example of a planar layout of the peeling layer 100 included in the first wafer W1 before bonding, in the semiconductor device 1 according to the first embodiment. As shown in FIG. 10, the thermally conductive layer 130 and the thermally conductive layer 140 are arranged to constitute a mesh-like structure in a planar view. Each thermally conductive layer 130 has a portion extending in the X direction. The portions extending in the X direction of the respective thermally conductive layers 130 are arranged in a line-and-space pattern in a planar view, namely, arranged at substantially regular intervals. For example, a space width in the Y direction of the portions of the thermally conductive layers 130 arranged in a line-and-space pattern is "S1".

Each thermally conductive layer 140 has a portion extending in the Y direction. The portions extending in the Y direction of the respective thermally conductive layers 140 are arranged in a line-and-space pattern in a planar view, namely, arranged at substantially regular intervals. For example, a space width in the X direction of the thermally conductive layers 140 arranged in a line-and-space pattern is "S2".

Each of the space widths S1 and S2 is designed to be a width that allows blocking of at least a part of the laser beam applied to the back surface of the first wafer W1 in the peeling process. Specifically, in a case where a CO₂ laser is used in the peeling process, the thermally conductive layers 130 and 140 can block the laser beam by designing each of the space widths S1 and S2 of the thermally conductive layers 130 and 140 to be narrower than the wavelength of the CO₂ laser (9.2 to 10.8 µm). The space widths S1 and S2 may be different from each other. The layer including the mesh-like structure constituted by the thermally conductive layers 130 and 140 is designed so that the reflectance at the wavelength of the laser beam LB is higher than that of the laser absorbing layer 120. In the description below, a region that does not overlap either the thermally conductive layers 130 or the thermally conductive layers 140 is referred to as a "space region SR".

### (7: Cross-Sectional Structure of Semiconductor Device 1)

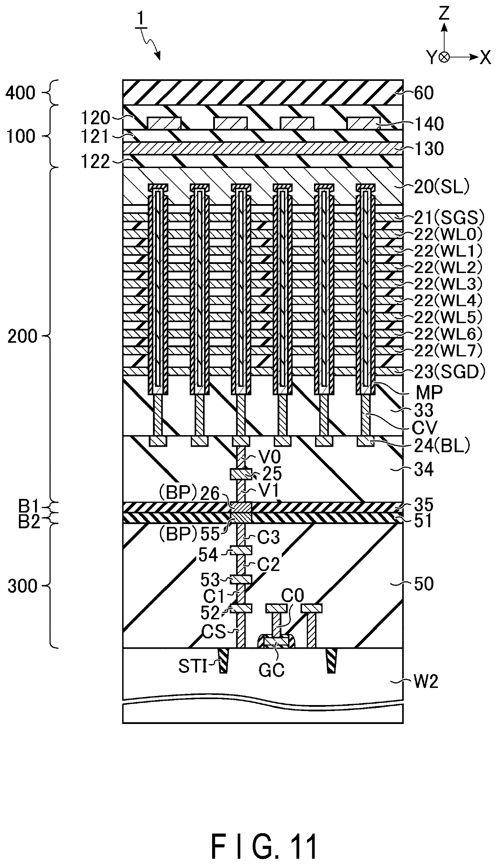

FIG. 11 is a cross-sectional view showing an example of a cross-sectional structure of the semiconductor device 1 according to the first embodiment. FIG. 11 shows a cross section including the memory region MR and indicates coordinate axes with respect to the second wafer W2. As shown in FIG. 11, the semiconductor device 1 has a structure in which the structure of the peeling layer 100 and the memory layer 200 is vertically inverted with respect to those shown in FIG. 8. The second wafer W2 includes a plurality of well regions (not shown). For example, a transistor is formed in each of the plurality of well regions. The plurality of well regions are separated by, for example, an STI (shallow trench isolation). The CMOS layer 300 includes, for example, an insulating layer 50, conductive layers GC and 52 through 54, and contacts CS and C0 through C3. For example, the bonding layer B2 includes an insulating layer 51 and a conductive layer 55. The interconnect layer 400 includes, for example, an insulating layer 60.

The insulating layer 50 is provided on the second wafer W2. The insulating layer 50 covers a circuit provided on the second wafer W2. The insulating layer 50 may be constituted by a plurality of insulating layers. The conductive layer 51 is provided on the insulating layer 50. The insulating layer 51 is in contact with the insulating layer 35. A boundary between the insulating layers 51 and 35 corresponds to a bonded surface of the first wafer W1 and the second wafer W2. The insulating layer 51 is, for example, a silicon oxide film.

The conductive layer GC is provided on a gate insulating film on the second wafer W2. The conductive layer GC is used as a gate electrode of a transistor. The contact C0 is provided on the conductive layer GC. The two contacts CS are coupled to two impurity diffusion layers (not shown) respectively corresponding to a source end and a drain end of the transistor. The conductive layers 52 are individually provided on the contacts CS and C0. The conductive layer 53 is provided on the conductive layer 52 via the contact C1. The conductive layer 54 is provided on the conductive layer 53 via the contact C2. The conductive layer 55 is provided on the conductive layer 54 via the contact C3. The conductive layer 55 corresponds to the bonding pad BP. The conductive layer 55 contains, for example, copper. The conductive layer 26 faces and is in contact with the conductive layer 55. As a result, the conductive layer 24 (bit line BL) is electrically coupled to the transistor provided on the second wafer W2.

The insulating layer 60 is provided on the laser absorbing layer 120 of the peeling layer 100. The interconnect layer 400 includes a conductive layer (not shown) coupled to a circuit included in either the memory layer 200 or the CMOS layer 300. The conductive layer is coupled to a pad PD (not shown) that is penetrating through the insulating layer 60. A part or the entirety of the peeling layer 100 may be removed after the first wafer W1 and the second wafer W2 are bonded together. In this case, the semiconductor device 1 includes no peeling layer 100 or includes part of the peeling layer 100. The interconnect that is coupled via the boding pad BP may be an interconnect other than the bit line BL.

### <1-2> Manufacturing Method

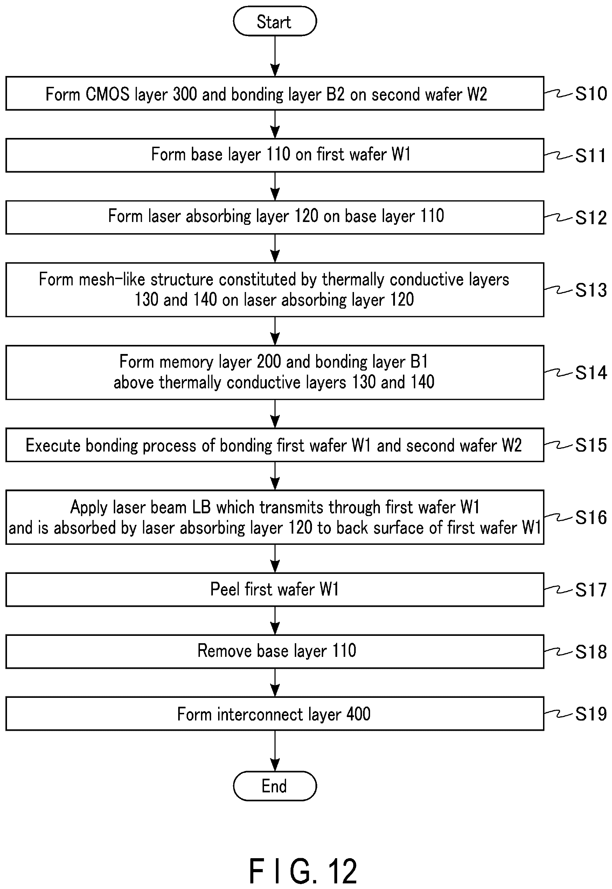

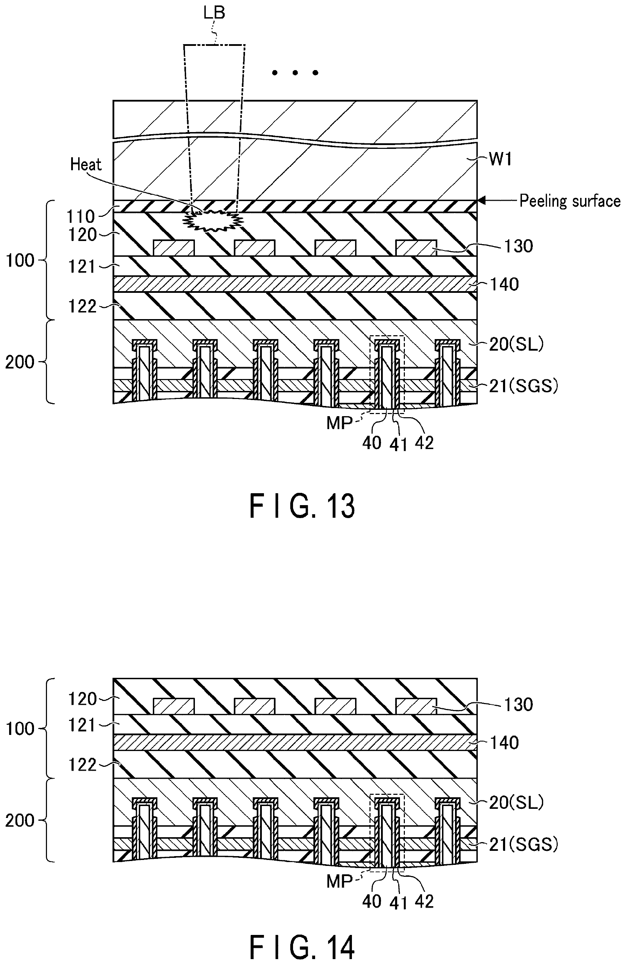

Next, a method of manufacturing the semiconductor device 1 according to the first embodiment will be described with reference to FIG. 12 where appropriate. FIG. 12 is a flowchart showing an example of the method of manufacturing the semiconductor device 1 according to the first embodiment. FIGS. 13 and 14 are cross-sectional views illustrating an example of a cross-sectional structure halfway through the manufacturing of the semiconductor device 1 according to the first embodiment, and show a portion near the peeling layer 100.

First, the CMOS layer 300 and the bonding layer B2 are formed on the second wafer W2 (S10). The process of S10 corresponds to a pre-processing step for the second wafer W2. The base layer 110 is formed on the first wafer W1 (S11). The laser absorbing layer 120 is formed on the base layer 110 (S12). The mesh-like structure constituted by the thermally conductive layers 130 and 140 is formed on the laser absorbing layer 120 (S13). The memory layer 200 and the bonding layer B1 are formed above the thermally conductive layers 130 and 140 (S14). The processes of S11 through S14 correspond to a pre-processing step for the first wafer W1. The process of S10 and the processes of S11 through S14 may be executed in parallel, or the order of these processes may be reversed.

Next, the bonding process of bonding the first wafer W1 and the second wafer W2 is executed (S15). By the process of S15, the bonding layer B1 formed on the first wafer W1 and the bonding layer B2 formed on the second wafer W2 are bonded together, so that the semiconductor circuit (for example, the memory cell array 10) formed on the first wafer W1 is electrically coupled to the semiconductor circuit (for example, the CMOS circuit, such as the row decoder module 16, the sense amplifier module 17, or the like) formed on the second wafer W2.

Next, as shown in FIG. 13, the laser beam LB that is transmitted through the first wafer W1 and is absorbed by the laser absorbing layer 120 is applied to the back surface of the first wafer W1 (S16). The laser beam LB to be used in the process of S16 is a non-polarized CO₂ laser having a wavelength of, for example, 9.2 to 10.8 µm. The laser beam LB is transmitted through the first wafer W1 and reaches the peeling layer 100. The laser absorbing layer 120 absorbs the laser beam LB, thereby generating heat. Then, the portion of the first wafer W1 that is near the peeling surface is plastically deformed in accordance with the heat generated in the laser absorbing layer 120. The propagation of the heat generated in the laser absorbing layer 120 to the memory layer 200 is suppressed by the mesh-like structure constituted by the thermally conductive layers 130 and 140. In other words, the heat generated in the laser absorbing layer 120 propagates more to the thermally conductive layers 130 and 140 than to the memory layer 200. Then, the laser beam LB is applied to the back surface of the first wafer W1 at predetermined intervals while the irradiation position is being changed. The wavelength of the laser beam LB to be used in the process of S16 is longer than the space widths S1 and S2 in the mesh-like structure constituted by the thermally conductive layers 130 and 140. Accordingly, at least a part of the laser beam LB applied to the back surface of the first wafer W1 is blocked by the mesh-like structure constituted by the thermally conductive layers 130 and 140.

Next, the first wafer W1 is peeled off (S17). The process of S17 causes the first wafer W1 to be peeled off at a peeling surface between the base layer 110 and the first wafer W1, and forms a structure in which the CMOS layer 300 and the memory layer 200 remain on the second wafer W2. Next, as shown in FIG. 14, the base layer 110 is removed (S18). In the process of S18, the laser absorbing layer 120 and parts of the thermally conductive layers 130 and 140 may be removed. Next, the interconnect layer 400 is formed (S19). The process of S19 forms a plurality of pads PD coupled to either the semiconductor circuit included in the memory layer 200 or the semiconductor circuit included in the CMOS layer 300 on the surface of the semiconductor device 1. As a result, the structure of the semiconductor device 1 shown in FIG. 11 is formed.

### <1-3> Advantageous Effects of First Embodiment

According to the structure of the semiconductor device 1 and the manufacturing method of the first embodiment described above, the manufacturing cost and the deterioration of device characteristics of the semiconductor device can be suppressed. Details of advantageous effects of the first embodiment will be described below.

As a method for manufacturing a semiconductor device having a bonded structure, a method is known in which, after a first wafer W1 and a second wafer W2 are bonded together, the first wafer W1 is removed by a CMP process or the like. If the first wafer W1 after bonding is reused for manufacturing of another semiconductor device, costs for drainage treatment involved in the CMP process or wafer costs can be suppressed. Therefore, forming a peeling layer 100 before a semiconductor circuit is formed on the first wafer W1 and executing a peeling process by laser peeling using the peeling layer 100 as a starting point has been studied.

In the laser peeling, for example, the portion near the surface of the first wafer W1 is plastically deformed due to the silicon oxide film included in the peeling layer 100 being heated by the laser beam LB. Then, a crack is produced at a bonding surface between the first wafer W1 and the second wafer W2, so that the first wafer W1 can be peeled off using the peeling layer 100 as a starting point. However, the laser peeling may be a cause of deterioration of device characteristics of the semiconductor circuit formed on the first wafer W1. Specifically, characteristics of the memory cell transistors MT or the like may be deteriorated due to the heating of the memory cell array 10 of the memory layer 200 formed in the first wafer W1.

On the other hand, the semiconductor device 1 according to the first embodiment has the peeling layer 100 including the mesh-like structure constituted by the thermally conductive layers 130 and 140. The mesh-like structure constituted by the thermally conductive layers 130 and 140 is formed of a material having a coefficient of thermal conductivity higher than that of the laser absorbing layer 120 configured to absorb the laser beam LB. Accordingly, the mesh-like structure constituted by the thermally conductive layers 130 and 140 can facilitate thermal diffusion when the laser beam LB is applied, and can suppress propagation of the heat to the memory cell array 10.

Each of the thermally conductive layers 130 and 140 constituting the mesh-like structure has a line-and-space pattern having a space width smaller than the wavelength of the laser beam LB. With this pattern, the mesh-like structure constituted by the thermally conductive layers 130 and 140 can block at least a part of the laser beam LB applied to the back surface of the first wafer W1. Thus, the mesh-like structure constituted by the thermally conductive layers 130 and 140 can suppress the memory cell array 10 from being heated by the laser beam LB.

As a result, according to the configuration of the semiconductor device 1 and the manufacturing method of the first embodiment, the device characteristics of the semiconductor circuit can be suppressed from being deteriorated by the laser peeling. In addition, according to the configuration of the semiconductor device 1 and the manufacturing method of the first embodiment, since the device characteristics of the semiconductor circuit can be suppressed from being deteriorated, the manufacturing process for a semiconductor device reusing the first wafer W1 is available. Thus, according to the configuration of the semiconductor device 1 and the manufacturing method of the first embodiment, wafer costs or the like can be suppressed, and the manufacturing cost of the semiconductor device can also be suppressed.

### <1-4> Modifications of First Embodiment

The arrangements and shapes of the thermally conductive layers 130 and 140 of the first embodiment described above may be replaced with other arrangements and shapes. Other examples of the arrangements and shapes of the thermally conductive layers 130 and 140 will be described below as a first modification and a second modification of the first embodiment.

### (1: First Modification)

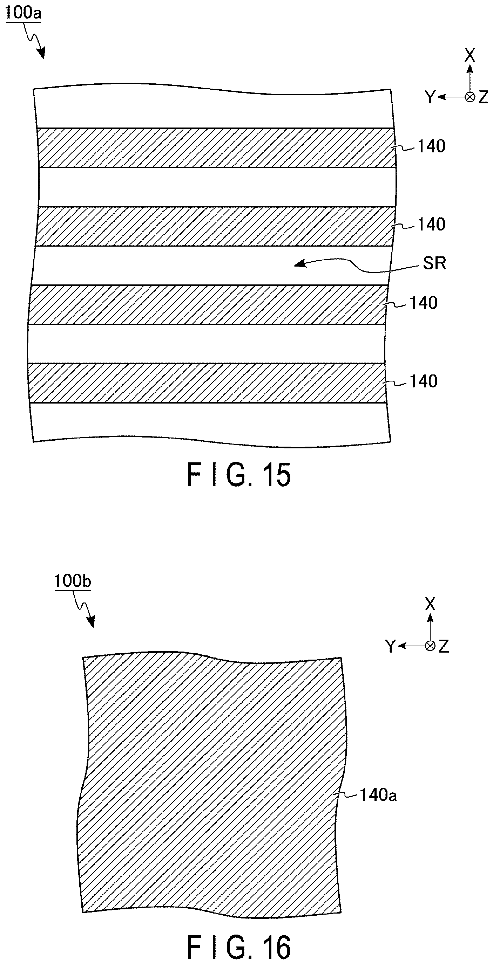

FIG. 15 is a plan view showing an example of a planar layout of a peeling layer 100a according to the first modification. As shown in FIG. 15, the peeling layer 100a has a configuration in which the thermally conductive layers 130 are omitted from the peeling layer 100 of the first embodiment. Thus, the peeling layer 100 does not necessary comprise thermally conductive layers 130 arranged like a mesh. Alternatively, the peeling layer 100a may have a configuration in which the thermally conductive layers 140 are omitted from the peeling layer 100 of the first embodiment. That is, the peeling layer 100a may include at least either the thermally conductive layers 130 or the thermally conductive layers 140. Also in such a case, the peeling layer 100a can realize functions and advantageous effects similar to those of the peeling layer 100 of the first embodiment, in accordance with the design of the thermally conductive layers 130 or 140 having a line-and-space pattern.

### (2: Second Modification)

FIG. 16 is a plan view showing an example of a planar layout of a peeling layer 100b according to the second modification. As shown in FIG. 16, the peeling layer 100b has a configuration in which the thermally conductive layers 130 are omitted from the peeling layer 100 of the first embodiment, and a plate-like thermally conductive layer 140 is provided. Thus, the design of each of the thermally conductive layers 130 and 140 in the peeling layer 100 is not limited to a line-and-space pattern. Also in such a case, the peeling layer 100b can realize functions and advantageous effects similar to those of the peeling layer 100 of the first embodiment, in accordance with the design of at least one plate-like thermally conductive layer 130 or 140.

In the semiconductor device 1, it suffices that the peeling layer 100 of the first wafer W1 before bonding includes at least one of: the mesh-like structure constituted by the thermally conductive layers 130 and 140 of the first embodiment; the thermally conductive layers 130 or 140 of the first modification; and the thermally conductive layer 130 or 140 of the second modification, or includes any combination of these layers.

### <2> Second Embodiment

The second embodiment relates to a configuration and a manufacturing method of the semiconductor device 1 using a stacked structure of the peeling layer to allow suppression of deterioration of device characteristics of a semiconductor circuit due to a peeling step to enable reuse of a wafer. In the following, the second embodiment is mainly explained in terms of the differences from the first embodiment.

### <2-1> Configuration

First, the configuration of the semiconductor device 1 according to the second embodiment is described. The configuration of the semiconductor device 1 of the second embodiment is different from the first embodiment in structure of the peeling layer 100 in the first wafer W1 before bonding and in structure of the peeling layer 100 after bonding.

### (1: Cross-Sectional Structure of First Wafer W1)

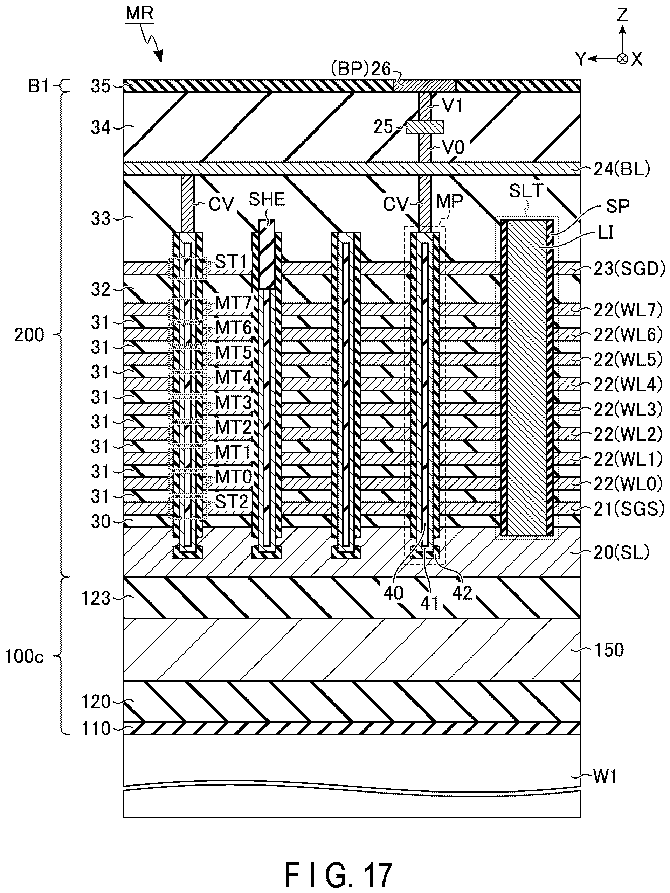

FIG. 17 is a cross-sectional view showing an example of a cross-sectional structure of the first wafer W1 before bonding, in a semiconductor device according to the second embodiment. FIG. 17 shows an example of a structure of the memory region MR of the memory cell array 10 formed on the first wafer W1 before being bonded to the second wafer W2, and indicates coordinate axes with reference to the first wafer W1. As shown in FIG. 17, the semiconductor device 1 according to the second embodiment has a configuration in which the peeling layer 100 of the semiconductor device 1 of the first embodiment is replaced with a peeling layer 100c. Specifically, the peeling layer 100c includes a base layer 110, a laser absorbing layer 120, an insulating layer 123, and a blocking layer 150.

The base layer 110 is provided on the first wafer W1. The laser absorbing layer 120 is provided on the base layer 110. The blocking layer 150 is provided on the laser absorbing layer 120. The blocking layer 150 covers at least a portion above the region of the first wafer W1 where the memory cell array 10 is formed. As the blocking layer 150, a material having a light blocking effect for blocking the laser beam LB is used. For example, the blocking layer 150 is formed of metal, impurity-doped silicon, or a porous material such as glass, silicon, or alumina, etc. The blocking layer 150 may be formed of a plurality of kinds of material. The blocking layer 150 made of metal realizes light blocking almost by reflection. The blocking layer 150 made of a semiconductor or insulating material realizes light blocking by not transmitting the laser beam LB. That is, the blocking layer 150 realizes light blocking by light reflection at an interface between the laser absorbing layer 120 and the blocking layer 150 and/or by light absorption in the blocking layer 150.

The blocking layer 150 configured as described above can suppress the laser beam applied to the back surface of the first wafer W1 from reaching the memory layer 200. As the blocking layer 150, a material having a thermal conductivity lower than that of the laser absorbing layer 120 may be used. In this case, the blocking layer 150 can suppress propagation of the heat generated by the laser absorbing layer 120 to the memory layer 200. As the blocking layer 150, alternatively, a material having a thermal conductivity higher than that the laser absorbing layer 120 may be used. In this case, similarly to the thermal diffusion layer of the first embodiment, the blocking layer 150 can facilitate thermal diffusion when the laser beam LB is applied, and can suppress propagation of the heat to the memory cell array 10. The blocking layer 150 having a thermal diffusion function may be referred to as a "thermal diffusion layer". The insulating layer 123 is provided on the blocking layer 150. The insulating layers 123 may be formed of the same material as, or different material from, that of the laser absorbing layer 120. The other configurations of the first wafer W1 before bonding in the semiconductor device 1 according to the second embodiment are the same as those of the first embodiment.

### (2: Cross-Sectional Structure of Semiconductor Device 1)

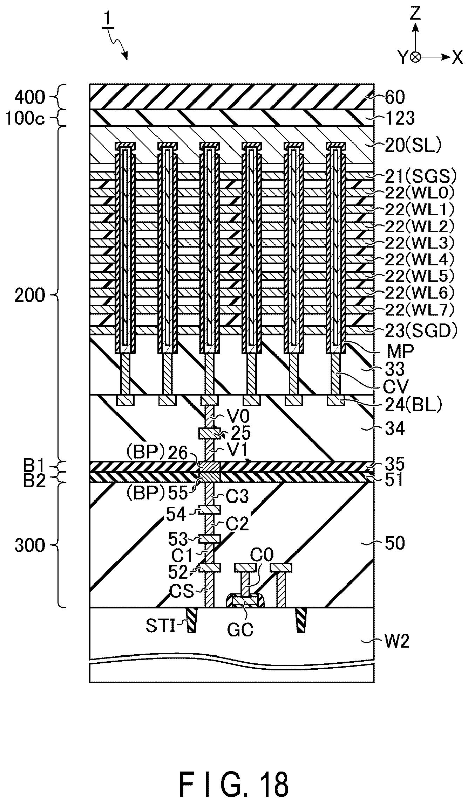

FIG. 18 is a cross-sectional view showing an example of a cross-sectional structure of the semiconductor device 1 according to the second embodiment. FIG. 18 shows a cross section including the memory region MR and indicates coordinate axes with respect to the second wafer W2. As shown in FIG. 18, the semiconductor device 1 of the second embodiment has a structure in which a set of a part of the peeling layer 100c shown in FIG. 17 and the memory layer 200 is vertically inverted with respect to that shown in FIG. 17. Specifically, the peeling layer 100c includes the insulating layer 123. The insulating layer 60 is provided on the insulating layer 123. That is, in the second embodiment, after the first wafer W1 and the second waver W2 are bonded together, a set of the base layer 110, the laser absorbing layer 120, and the blocking layer 150 is removed. The other configurations in the semiconductor device 1 according to the second embodiment are the same as those of the first embodiment.

### <2-2> Manufacturing Method

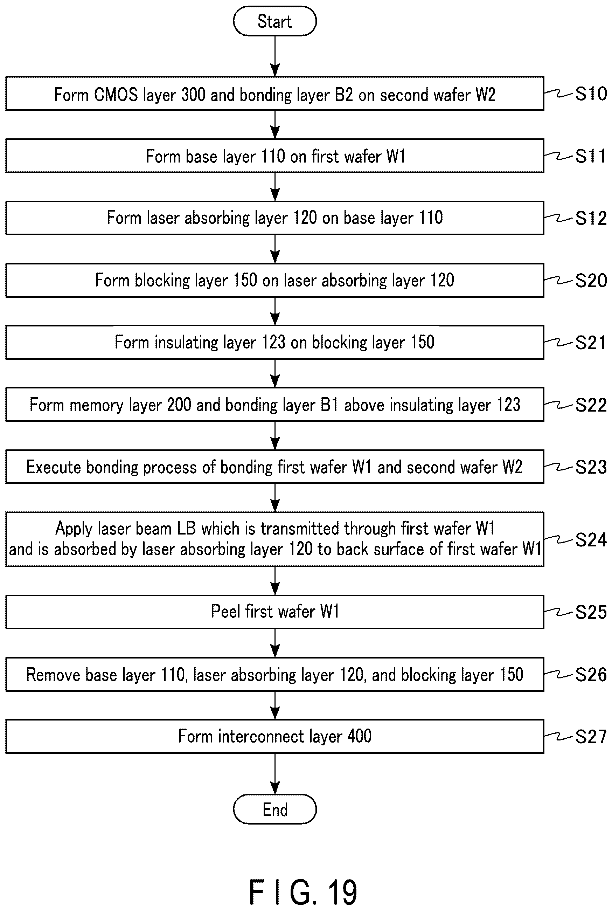

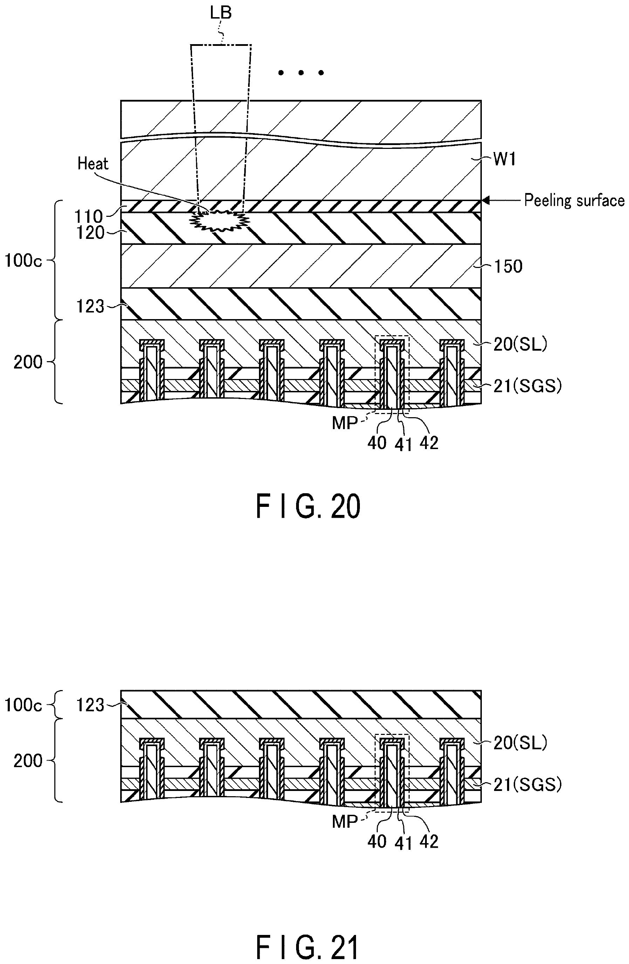

Next, a method of manufacturing the semiconductor device 1 according to the second embodiment will be described with reference to FIG. 19 where appropriate. FIG. 19 is a flowchart showing an example of the method of manufacturing the semiconductor device 1 according to the second embodiment. FIGS. 20 and 21 are cross-sectional views illustrating an example of a cross-sectional structure halfway through the manufacturing of the semiconductor device 1 according to the second embodiment, and show a portion near the peeling layer 100c.

First, the CMOS layer 300 and the bonding layer B2 are formed on the second wafer W2 (S10). The process of S10 corresponds to a pre-processing step for the second wafer W2. The base layer 110 is formed on the first wafer W1 (S11). The laser absorbing layer 120 is formed on the base layer 110 (S12). The blocking layer 150 is formed on the laser absorbing layer 120 (S20). The insulating layer 123 is formed on the blocking layer 150 (S21). The memory layer 200 and the bonding layer B1 are formed above the insulating layers 123 (S22). The processes of S11, S12, and S20 through S22 correspond to a pre-processing step for the first wafer W1. The process of S10 and the processes of S11, S12, and S20 through S22 may be executed in parallel, or the order of these processes may be reversed.

Next, the bonding process of bonding the first wafer W1 and the second wafer W2 is executed (S23). By the process of S23, the bonding layer B1 formed on the first wafer W1 and the bonding layer B2 formed on the second wafer W2 are bonded together, so that the semiconductor circuit formed on the first wafer W1 is electrically coupled to the semiconductor circuit formed on the second wafer W2.

Next, as shown in FIG. 20, the laser beam LB that is transmitted through the first wafer W1 and is absorbed by the laser absorbing layer 120 is applied to the back surface of the first wafer W1 (S24). The laser beam LB transmits through the first wafer W1 and reaches the peeling layer 100. The laser absorbing layer 120 absorbs the laser beam LB, thereby generating heat. Then, the portion of the first wafer W1 that is near the peeling surface is plastically deformed in accordance with the heat generated in the laser absorbing layer 120. Furthermore, the laser beam LB applied to the back surface of the first wafer W1 is suppressed from reaching the memory layer 200 by the blocking layer 150. In other words, the laser beam LB transmitted through the laser absorbing layer 120 is blocked by light reflection at an interface between the laser absorbing layer 120 and the blocking layer 150 and/or by light absorption in the blocking layer 150. Then, the laser beam LB is applied to the back surface of the first wafer W1 at predetermined intervals while the irradiation position is being changed. At least a part of the laser beam LB applied to the back surface of the first wafer W1 is blocked by the blocking layer 150.

Next, the first wafer W1 is peeled off (S25). The process of S25 causes the first wafer W1 to be peeled off at a peeling surface between the base layer 110 and the first wafer W1, and forms a structure in which the CMOS layer 300 and the memory layer 200 remain on the second wafer W2. Next, as shown in FIG. 21, the base layer 110, the laser absorbing layer 120, and the blocking layer 150 are removed (S26). In the process of S26, a part of the insulating layer 123 may be removed. Next, the interconnect layer 400 is formed (S27). As a result, the structure of the semiconductor device 1 shown in FIG. 18 is formed.

### <2-3> Advantageous Effects of Second Embodiment

The first wafer W1 of the semiconductor device 1 according to the second embodiment includes the peeling layer 100c including the blocking layer 150. The blocking layer 150 can suppress the laser beam LB applied to the back surface of the first wafer W1 from reaching the memory layer 200. Specifically, the blocking layer 150 blocks the laser beam LB by light reflection at an interface between the laser absorbing layer 120 and the blocking layer 150 and/or by light absorption in the blocking layer 150. Accordingly, the blocking layer 150 can suppress heat generation in the memory layer 200 (for example, the memory cell array 10) due to radiation of the laser beam LB. Therefore, according to the structure of the semiconductor device 1 and the manufacturing method of the second embodiment, similarly to the first embodiment, the manufacturing cost and the deterioration of device characteristics of the semiconductor device can be suppressed.

If the blocking layer 150 is formed of a porous structure (for example, porous silicon), the physical contact area between the memory cell array 10 and the blocking layer 150 is reduced. In other words, if the blocking layer 150 is formed of a porous structure, a heat inflow path from the blocking layer 150 to the memory cell array 10 is reduced as compared to a case in which the blocking layer 150 is formed of a non-porous structure. As a result, the blocking layer 150 of the porous structure can suppress the heat inflow from the blocking layer 150 to the memory cell array 10.

### <3> Third Embodiment

The third embodiment relates to a configuration and a manufacturing method of the semiconductor device 1 using the blocking layer 150 and including a memory cell array 10 in which a source line SL is formed after bonding. In the following, the third embodiment is mainly explained in terms of the differences from the first and second embodiments.

### <3-1> Configuration

First, the configuration of the semiconductor device 1 according to the third embodiment is described. The configuration of the semiconductor device 1 of the third embodiment is different from the second embodiment in structure of the peeling layer 100 in the first wafer W1 before bonding and in structure of the source line SL after bonding.

### (1: Cross-Sectional Structure of First Wafer)

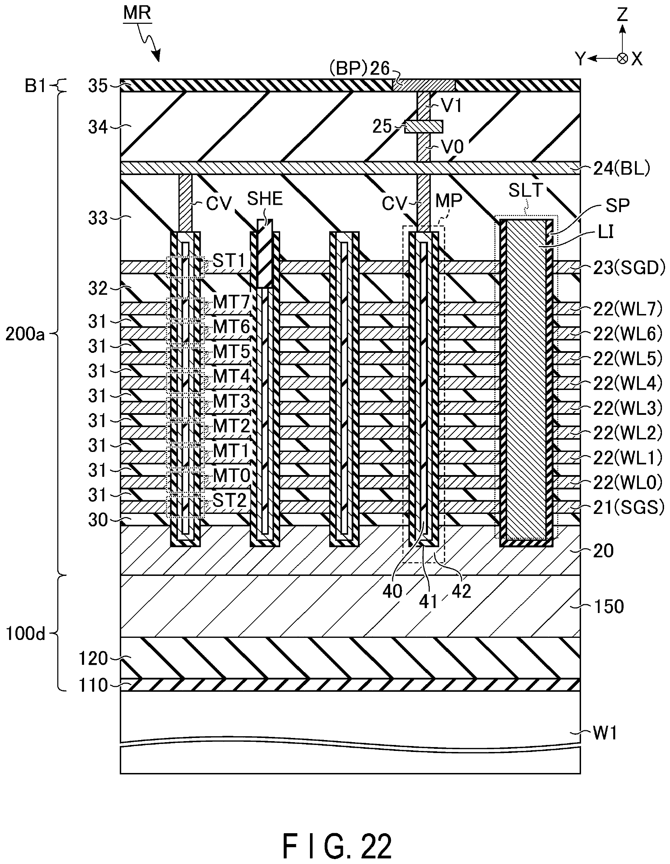

FIG. 22 is a cross-sectional view showing an example of a cross-sectional structure of the first wafer before bonding, in the semiconductor device 1 according to the third embodiment. FIG. 22 shows an example of a structure of the memory region MR of the memory cell array 10 formed on the first wafer W1 before being bonded to the second wafer W2, and indicates coordinate axes with reference to the first wafer W1. As shown in FIG. 22, the semiconductor device 1 according to the third embodiment has a configuration in which the peeling layer 100c of the semiconductor device 1 of the second embodiment is replaced with a peeling layer 100d, and the memory layer 200 of the second embodiment is replaced with a memory layer 200a. Specifically, the peeling layer 100d includes a base layer 110, a laser absorbing layer 120, and a blocking layer 150. The memory layer 200a is different from the memory layer 200 in structure of the memory pillar MP and the slit SLT.

The base layer 110 is provided on the first wafer W1. The laser absorbing layer 120 is provided on the base layer 110. The blocking layer 150 is provided on the laser absorbing layer 120. The blocking layer 150 covers at least a portion above the region of the first wafer W1 where the memory cell array 10 is formed. As the blocking layer 150, a material having a light blocking effect for blocking the laser beam LB is used. For example, the blocking layer 150 is formed of metal, impurity-doped silicon, or a porous material such as glass, silicon, or alumina, etc. The conductive layer 20 is provided on the blocking layer 150. Thus, in this example, the insulating layer 123 is omitted and the conductive layer 20 and the blocking layer 150 are in contact. Alternatively, the semiconductor device 1 according to the third embodiment may be provided with an insulating layer 123 between the conductive layer 20 and the blocking layer 150. The insulating layer 123 can protect the memory layer 200 in the peeling process for the first wafer W1.

In the third embodiment, the semiconductor layer 41 in each memory pillar MP is separated from the conductive layer 20 by the stacked film 42. The contact LI of each slit SLT is separated from the conductive layer 20 by the spacer SP. Thus, in the first wafer W1 before bonding according to the third embodiment, the semiconductor layer 41 of each memory pillar MP and the contact LI of each slit SLT are each insulated from the conductive layer 20. The other configurations of the first wafer W1 before bonding in the semiconductor device 1 according to the third embodiment are the same as those of the second embodiment.

### (2: Cross-Sectional Structure of Semiconductor Device 1)

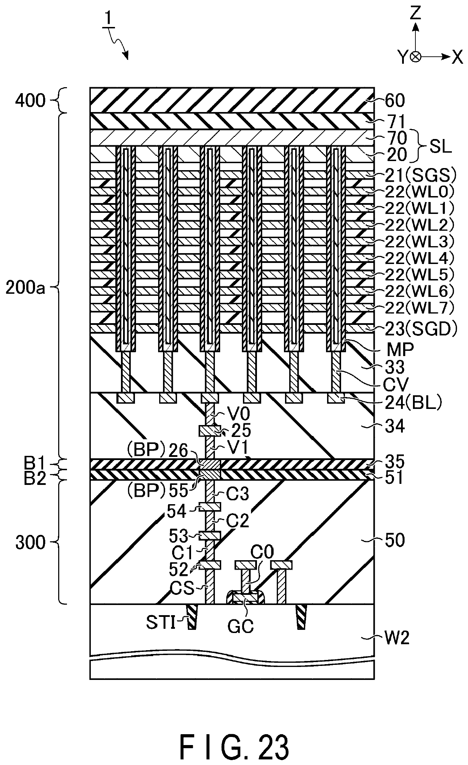

FIG. 23 is a cross-sectional view showing an example of a cross-sectional structure of the semiconductor device 1 according to the third embodiment. FIG. 23 shows a cross section including the memory region MR and indicates coordinate axes with respect to the second wafer W2. As shown in FIG. 23, the semiconductor device 1 of the third embodiment has a structure in which a part of the memory layer 200a is vertically inverted with respect to that shown in FIG. 22, a conductive layer 70 and an insulating layer 71 are added to the vertically inverted structure, and the peeling layer 100d is omitted. Specifically, the conductive layer 20 after bonding is thinner than the conductive layer 20 in the first wafer W1 before bonding. The height of the upper surface of the conductive layer includes the semiconductor layer 41 of each memory pillar MP. Each memory pillar MP has a structure in which the stacked film 42 provided at least on the semiconductor layer 41 has been removed. The conductive layer 70 is provided on the insulating layer 20. The conductive layer 70 is electrically coupled to the Semiconductor layer 41 of each memory pillar MP. The insulating layer 71 is provided on the conductive layer 70. The insulating layer 71 may include a contact and an interconnect layer coupled to a source line SL. The insulating layer 60 is provided on the insulating layer 71. That is, in the third embodiment, after the first wafer W1 and the second wafer W2 are bonded together, the set of the base layer 110, the laser absorbing layer 120, and the blocking layer 150 are removed. The other configurations in the semiconductor device 1 according to the third embodiment are the same as those of the second embodiment.

### <3-2> Manufacturing Method

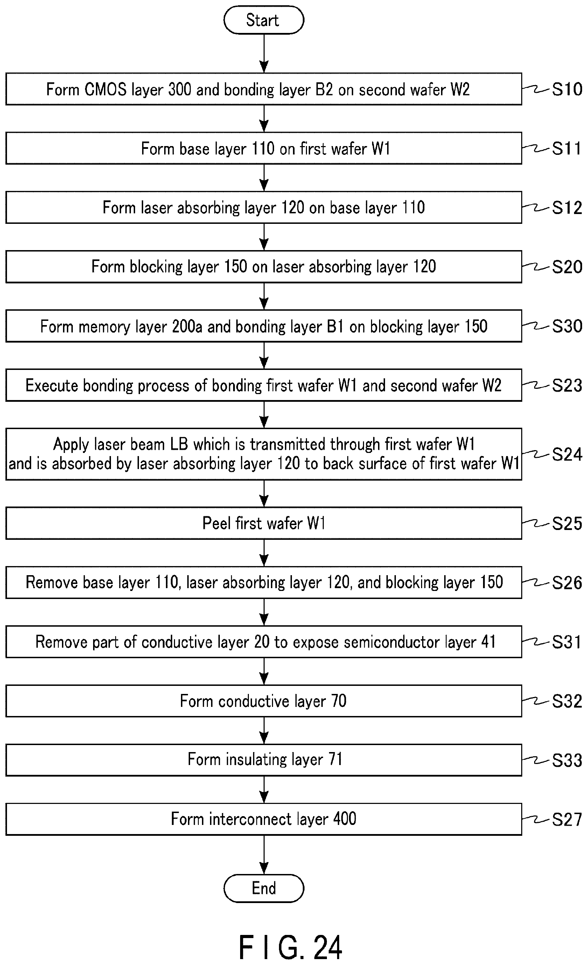

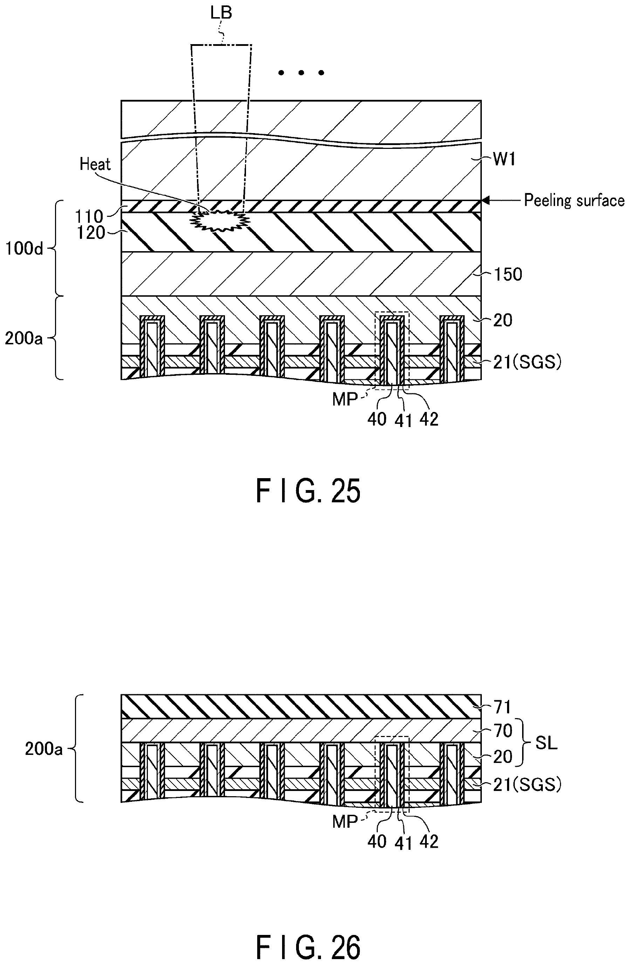

Next, a method of manufacturing the semiconductor device 1 according to the third embodiment will be described with reference to FIG. 24 where appropriate. FIG. 24 is a flowchart showing an example of the method of manufacturing the semiconductor device 1 according to the third embodiment. FIGS. 25 and 26 are cross-sectional views illustrating an example of a cross-sectional structure halfway through the manufacturing of the semiconductor device 1 according to the third embodiment, and show a portion near the peeling layer 100d.

First, the CMOS layer 300 and the bonding layer B2 are formed on the second wafer W2 (S10). The process of S10 corresponds to a pre-processing step for the second wafer W2. The base layer 110 is formed on the first wafer W1 (S11). The laser absorbing layer 120 is formed on the base layer 110 (S12). The blocking layer 150 is formed on the laser absorbing layer 120 (S20). The memory layer 200a and the bonding layer B1 are formed on the blocking layer 150 (S30). The processes of S11, S12, S20, and S30 correspond to a pre-processing step for the first wafer W1. The process of S10 and the processes of S11, S12, S20, and S30 may be executed in parallel, or the order of these processes may be reversed

Next, the bonding process of bonding the first wafer W1 and the second wafer W2 is executed (S23). By the process of S23, the bonding layer B1 formed on the first wafer W1 and the bonding layer B2 formed on the second wafer W2 are bonded together, so that the semiconductor circuit formed on the first wafer W1 is electrically coupled to the semiconductor circuit formed on the second wafer W2.

Next, as shown in FIG. 25, the laser beam LB that is transmitted through the first wafer W1 and is absorbed by the laser absorbing layer 120 is applied to the back surface of the first wafer W1 (S24). The laser beam LB is transmitted through the first wafer W1 and reaches the peeling layer 100. The laser absorbing layer 120 absorbs the laser beam LB, thereby generating heat. Then, the portion of the first wafer W1 that is near the peeling surface is plastically deformed in accordance with the heat generated in the laser absorbing layer 120. The blocking layer 150 can suppress the laser beam LB applied to the back surface of the first wafer W1 from reaching the memory layer 200a, similarly to the second embodiment. Then, the laser beam LB is applied to the back surface of the first wafer W1 at predetermined intervals while the irradiation position is being changed.

Next, the first wafer W1 is peeled off (S25). The process of S25 causes the first wafer W1 to be peeled off at a peeling surface between the base layer 110 and the first wafer W1, and forms a structure in which the CMOS layer 300 and the memory layer 200a remain on the second wafer W2. Next, the base layer 110, the laser absorbing layer 120, and the blocking layer 150 are removed (S26). Next, a part of the conductive layer 20 is removed to expose the semiconductor layer 41 (S31). In the process of S31, for example, a chemical mechanical polishing (CMP) is used. The processes of S30 and S31 may be sequentially executed by the same semiconductor manufacturing device. Next, as shown in FIG. 26, the conductive layer 70 is formed (S32), and the insulating layer 71 is formed (S33). Thereafter, the interconnect layer 400 is formed (S27). As a result, the structure of the semiconductor device 1 shown in FIG. 23 is formed.

### <3-3> Advantageous Effect of Third Embodiment

In the semiconductor device 1 according to the third embodiment, the semiconductor layer 41 of the memory pillar MP and the source line SL are electrically coupled after the bonding process is executed. Also with this configuration, similarly to the second embodiment, the structure of the semiconductor device 1 and the manufacturing method of the third embodiment can suppress the manufacturing cost and the deterioration of device characteristics of the semiconductor device.

### <4> Modifications or the like

Each of the embodiments described above can be modified in various manners. The embodiments can be combined where appropriate. For example, in the semiconductor device 1, the thermal diffusion layer of the first embodiment and the blocking layer 150 of the second and third embodiments may be used in combination. In this case, the peeling layer 100 of the first wafer W1 before bonding includes both the thermal diffusion layer of the first embodiment and the blocking layer 150 of the second and third embodiments. The semiconductor device 1 may have a structure having both a function of thermal diffusion of the thermal diffusion layer and a function of blocking light of the blocking layer 150.

The blocking layer 150 in the second and third embodiments is, for example, a layer of polysilicon having numerous fine holes (porous silicon layer). The mechanical strength of the porous silicon layer is lower than a polysilicon layer. Therefore, in the peeling process of the second and third embodiments, the first wafer W1 may be peeled off using the blocking layer 150 as a peeling surface. In this case, the peeled-off first wafer W1 can include a porous silicon layer (blocking layer 150) divided by a crack. The peeled-off first wafer W1 can be reused by removing the porous silicon layer. The porous silicon layer is formed by, for example, forming a polysilicon layer on a silicon substrate and then anodizing the formed polysilicon layer.

A manufacturing method for the porous silicon layer (blocking layer 150) and the like will be described. First, a semiconductor layer is formed on a portion corresponding to the blocking layer 150. The semiconductor layer is, for example, an amorphous semiconductor layer, such as an amorphous silicon layer, which contains impurity atoms at a high concentration. The impurity atoms contained in the semiconductor layer are, for example, hydrogen (H) atoms. The H atom concentration in the semiconductor layer is, for example, 1.0×10²¹/cm³ or higher. The impurity atoms are not limited to H atoms, but may be, for example, rare gas atoms, such as helium (He) atoms. Then, laser annealing of the first wafer W1 is executed, thereby heating and melting the semiconductor layer. The melting temperature of the semiconductor layer is, for example, 1300 °C or higher. Thereafter, the semiconductor layer is crystallized. The crystallized semiconductor layer corresponds to a porous semiconductor layer, such as a porous polysilicon layer. Thus, the porous silicon layer (blocking layer 150), which is a polysilicon layer and a porous layer, can be formed by making the semiconductor layer porous. The laser annealing in this example is executed by using, for example, ultraviolet light (UV light). The intensity of the UV light is set to, for example, 0.3-2.0 J/cm². The laser annealing in this example may be executed by any laser light other than UV light; for example, light having a wavelength shorter than the wavelength of visible light may be used. Pore formation in this example occurs due to impurity atoms collected in the semiconductor layer and forming numerous voids like bubbles (pores). Furthermore, a cap insulating film may be formed on the semiconductor layer that is used for forming the blocking layer 150. The cap insulating film can suppress increase in the roughness of the upper surface of the semiconductor layer due to voids that occur from pore formation. As the cap insulating film, for example, silicon nitride (SiN) film is used. The melting point of silicon nitride is higher than the melting point of silicon oxide film. As a result, the cap insulating film can efficiently suppress the increase in the roughness due to voids.

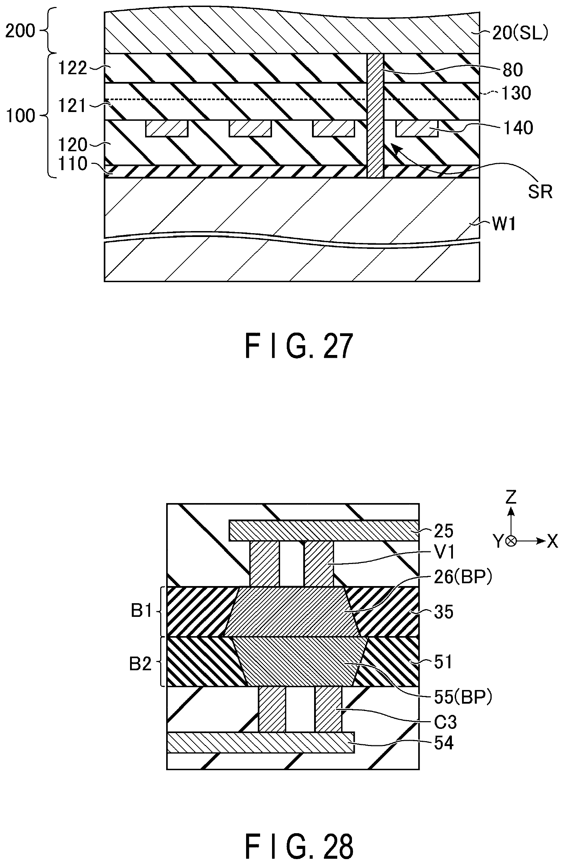

FIG. 27 is a cross-sectional view showing an example of a cross-sectional structure of the first wafer W1 before bonding, in the semiconductor device 1 according to the first embodiment. As shown in FIG. 27, the first wafer W1 before bonding may include a contact 80. The contact 80 electrically couples the surface of the first wafer W1 and the conductive layer 20 via a space region SR. The contact 80 may be used as a channel for releasing charges generated in a deep etching process or the like, when forming a memory pillar MP. The portion coupled to the contact 80 in the conductive layer 20 may be divided after the deep etching process, or may have a layer structure different from the memory region MR. The contact 80 may have a structure in which a plurality of contacts or conductive layers are coupled in the Z direction. The contact 80 may be combined with either the second or third embodiment.

FIG. 28 is a cross-sectional view showing an example of a detailed cross-sectional structure of a bonded portion of the bonding pad BP. FIG. 28 shows a conductive layer 26 (bonding pad BP) of the bonding layer B1 and a conductive layer 55 (bonding pad BP) of the bonding layer B2, and parts of contacts and interconnects to be bonded to the bonding pads BP. As shown in FIG. 28, the two bonding pads BP have different tapered shapes depending on the etching direction during formation. Specifically, the conductive layer 55 formed using the second wafer W2 has, for example, a reverse tapered shape. The conductive layer 26 formed using the first wafer W1 has, for example, a tapered shape. Thus, a set of bonding pads BP coupling the semiconductor circuit of the memory layer 200 and the CMOS layer 300 has a reverse tapered portion on the CMOS layer 300 side and a tapered portion on the memory layer 200 side. Since the bonding pad BP having a reverse tapered shape is vertically inverted through the bonding process, it can be regarded as having a tapered shape if the first wafer W1 is a reference position. The two bonding pads BP that form a pair and face each other may be displaced and bonded together depending on alignment during the bonding process. Therefore, a level difference may be formed between the upper surface of the conductive layer 55 and the lower surface of the conductive layer 26. The two bonding pads BP that form a pair and face each other may have a boundary or may be integrated. The bonding pad BP and a contact coupled to the bonding pad BP may be integrated. A plurality of contacts may be coupled to each bonding pad BP. For example, the conductive layer 55 may be coupled to the conductive layer 54 via a plurality of contacts C3. Similarly, the conductive layer 26 may be coupled to the conductive layer 25 via a plurality of contacts V1.

In the above embodiments, the circuit configuration, planar layout, and cross-sectional structure of the semiconductor device 1 may be suitably changed. For example, the semiconductor layer 41 of the memory pillar MP and the source line SL may be coupled via the bottom portion of the memory pillar MP. The memory pillar MP may have a structure in which two or more pillars are coupled in the Z direction. The memory pillar MP may have a structure in which a pillar corresponding to a select gate line SGD and a pillar corresponding to a word line WL are coupled. Each contact may be formed of a plurality of contacts coupled in the Z direction. A conductive layer may be inserted into a connecting portion of the plurality of contacts. The number of interconnect layers and contacts in the semiconductor device 1 may be suitably changed.

In the embodiments described above, a case is described as an example in which the memory layer 200 is provided above the CMOS layer 300. However, the CMOS layer 300 may be provided above the memory layer 200. The semiconductor device 1 may include a plurality of memory layers 200 and a plurality of CMOS layers 300. In the drawings used for descriptions in the above embodiments, a case in which the memory pillar MP has the same diameter in the Z direction has been exemplified, but the present invention is not limited thereto. The memory pillar MP may have a tapered shape, reverse-tapered shape, or bowing shape. Similarly, each of the slits SLT and SHE may have a tapered or reverse-tapered shape, or bowing shape. Similarly, each contact may have a tapered shape, reverse-tapered shape, or bowing shape. A cross-sectional structure of each of the memory pillar MP and the contacts CC and C3 may be circular or elliptical.

Throughout the specification, the expression "coupling" refers to electrical coupling and does not exclude, for example, interposition of another element. Electrical coupling may have an insulator intervening as long as such coupling is capable of operating in a manner similar to electrical coupling without intervention of an insulator. The "tapered shape" indicates a shape that becomes narrower as it becomes farther away from the substrate, which serves as a reference position. The "reverse-tapered shape" indicates a shape that becomes broader as it becomes farther away from the substrate, which serves as a reference position. The "bowing shape" indicates a shape having a larger diameter in its central portion than an upper end portion and a lower end portion. The term "pillar" indicates a structure which is provided in a hole formed in the manufacturing step of the semiconductor device 1. The "width" indicates the width of a constituent element in, for example, the X direction or the Y direction. The "diameter" indicates the inside diameter of a hole or the outside diameter of the pillar in a cross section parallel to the surface of the substrate. The "wafer" or "semiconductor substrate" may be referred to as the "substrate". The "semiconductor layer" may also be referred to as a "conductive layer". The "region" may be considered a component included in the substrate that serves as a reference position. The "planar position" indicates a position of a structural element in a planar layout. The "top (planar) view" corresponds to a view of a target from, for example, a front surface side of the wafer.

Some or all of the embodiments described above can be described as in the following supplementary notes, but is not limited thereto:

### [Supplementary Note 1]

A method of manufacturing a semiconductor device, comprising:
forming a laser peeling film (120) above a first semiconductor substrate (W1);
forming, inside the laser peeling film, a thermal diffusion layer (130/140) while forming the laser peeling film, wherein the thermal diffusion layer includes a member having a coefficient of thermal conductivity higher than that of the laser peeling film is distributed in a plane parallel to a front surface of the first semiconductor substrate;
forming a circuit layer including a semiconductor circuit above the laser peeling film;
after forming the circuit layer, bonding the first semiconductor substrate and a second semiconductor substrate (W2) ;
after bonding the first semiconductor substrate and the second semiconductor substrate, applying a laser beam to a back surface of the first semiconductor substrate; and
after applying the laser beam to the back surface of the first semiconductor substrate, peeling the first semiconductor substrate to maintain the circuit layer on a side of the second semiconductor substrate.

### [Supplementary Note 2]

The method of Supplementary Note 1, wherein
the thermal diffusion layer is arranged to overlap the semiconductor circuit in a direction vertical to the first semiconductor substrate.

### [Supplementary Note 3]

The method of Supplementary Note 1, wherein
the thermal diffusion layer includes a plurality of first members (130), each extending in a first direction (X) parallel to the front surface of the first semiconductor substrate and having a coefficient of thermal conductivity higher than that of the laser peeling film, the first members being arranged at substantially regular intervals in a second direction (Y) parallel to the front surface of the first semiconductor substrate and intersecting the first direction.

### [Supplementary Note 4]

The method of Supplementary Note 3, wherein
the thermal diffusion layer includes a plurality of second members (140), each extending in the second direction, arranged at a height different from the first members, and having a coefficient of thermal conductivity higher than that of the laser peeling film, the second members being arranged at substantially regular intervals in the first direction.

### [Supplementary Note 5]

The method of Supplementary Note 2, wherein
the semiconductor circuit includes a plurality of first conductive layers (22), a pillar (MP), and a second conductive layer (SL), the first conductive layers being arranged in a vertical direction to the first semiconductor substrate, the pillar extending in the vertical direction and having a portion intersecting the first conductive layers, the second conductive layer being provided between the thermal diffusion layer and the first conductive layers,
the portion intersecting the pillar and the first conductive layers functions as a memory cell (MT), and
the pillar includes a semiconductor layer (41) coupled to the second conductive layer via a side surface.

### [Supplementary Note 6]

The method of Supplementary Note 1, further comprising:
while forming the laser peeling film, forming a blocking layer (150) which is distributed in a plane parallel to the front surface of the first semiconductor substrate inside the laser peeling film and has a light blocking effect for blocking the laser beam; and
after peeling the first semiconductor substrate, removing the blocking layer.

### [Supplementary Note 7]

The method of Supplementary Note 6, wherein
the blocking layer and the thermal diffusion layer are an identical layer.

### [Supplementary Note 8]

The method of Supplementary Note 6, wherein
the blocking layer includes metal, impurity-doped silicon, or a porous material of one selected from the group consisting of glass, silicon, and alumina.

### [Supplementary Note 9]

The method of Supplementary Note 1, wherein
the laser peeling film is a silicon oxide film.

### [Supplementary Note 10]

The method of Supplementary Note 1, further comprising:
before forming the laser peeling film, forming an interlayer film on the first semiconductor substrate, wherein
the interlayer film is either a semiconductor selected from the group consisting of epitaxial silicon, polycrystalline silicon, and amorphous silicon, or is a ceramic material.

### [Supplementary Note 11]

A semiconductor device comprising:
a semiconductor substrate (W2);
a first circuit layer (300) provided on the semiconductor substrate and including a first semiconductor circuit;
a bonding layer (B2) provided on the first circuit layer and including a plurality of pads (BP) coupled to the first semiconductor cisrcuit;
a second circuit layer (200) provided on the bonding layer and including a second semiconductor circuit coupled to the pads;
a laser peeling film (120) provided above the second circuit layer; and
a thermal diffusion layer (130/140) provided inside the laser peeling film, the thermal diffusion layer including a member distributed in a plane parallel to a front surface of the semiconductor substrate, and the member having a coefficient of thermal conductivity higher than that of the laser peeling film.

### [Supplementary Note 12]

The semiconductor device of Supplementary Note 11, wherein
the thermal diffusion layer is arranged to overlap the first semiconductor circuit in a direction vertical to the semiconductor substrate.

### [Supplementary Note 13]

The semiconductor device of Supplementary Note 11, wherein
the thermal diffusion layer includes a plurality of first members (130), each extending in a first direction (X) parallel to the front surface of the semiconductor substrate and having a coefficient of thermal conductivity higher than that of the laser peeling film, and
the first members are arranged at substantially regular intervals in a second direction (Y) parallel to the front surface of the semiconductor substrate and intersecting the first direction.

### [Supplementary Note 14]

The semiconductor device of Supplementary Note 13, wherein
a distance in the second direction between adjacent two of the first members is smaller than a wavelength of a laser beam transmitted through the semiconductor substrate and absorbed by the laser peeling film.

### [Supplementary Note 15]

The semiconductor device of Supplementary Note 13, wherein
the thermal diffusion layer includes a plurality of second members (140), each extending in the second direction, arranged at a height different from the first members, and having a coefficient of thermal conductivity higher than that of the laser peeling film, the second members being arranged at substantially regular intervals in the first direction.

### [Supplementary Note 16]

The semiconductor device of Supplementary Note 15, wherein
each of the distance in the second direction between adjacent two of the first members and the distance in the first direction between adjacent two of the second members is smaller than a wavelength of a laser beam transmitted through the semiconductor substrate and absorbed by the laser peeling film.

### [Supplementary Note 17]

The semiconductor device of Supplementary Note 11, wherein
the member is made of metal.

### [Supplementary Note 18]

The semiconductor device of Supplementary Note 11, wherein
the member has a porous structure.

### [Supplementary Note 19]

The semiconductor device of Supplementary Note 11, wherein
the second semiconductor circuit includes a plurality of memory cells (MT) capable of storing data in a nonvolatile manner, and
the first semiconductor circuit includes a CMOS circuit configured to control the memory cells.

### [Supplementary Note 20]

The semiconductor device of Supplementary Note 11, wherein
each of the pads has a reverse tapered portion on a side of the first circuit layer and a tapered portion on a side of the second circuit layer.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A method of manufacturing a semiconductor device, comprising:
forming a laser peeling film (120) above a first semiconductor substrate (W1);
forming a circuit layer including a semiconductor circuit above the laser peeling film;
after forming the circuit layer, bonding the first semiconductor substrate and a second semiconductor substrate (W2);
after bonding the first semiconductor substrate and the second semiconductor substrate, applying a laser beam to a back surface of the first semiconductor substrate; and
after applying the laser beam to the back surface of the first semiconductor substrate, peeling the first semiconductor substrate to maintain the circuit layer on a side of the second semiconductor substrate, wherein
forming the laser peeling film includes forming, inside the laser peeling film, a thermal diffusion layer (130/140) distributed in a plane parallel to a front surface of the first semiconductor substrate, and
the thermal diffusion layer includes a member having a coefficient of thermal conductivity higher than that of the laser peeling film.

2. The method of claim 1, wherein
the thermal diffusion layer is arranged to overlap the semiconductor circuit in a direction vertical to the first semiconductor substrate.

3. The method of claim 1, wherein
the thermal diffusion layer includes a plurality of first members (130), each extending in a first direction (X) parallel to the front surface of the first semiconductor substrate and having a coefficient of thermal conductivity higher than that of the laser peeling film, the first members being arranged at substantially regular intervals in a second direction (Y) parallel to the front surface of the first semiconductor substrate and intersecting the first direction.

4. The method of claim 3, wherein
the thermal diffusion layer includes a plurality of second members (140), each extending in the second direction, arranged at a height different from the first members, and having a coefficient of thermal conductivity higher than that of the laser peeling film, the second members being arranged at substantially regular intervals in the first direction.

5. The method of claim 2, wherein
the semiconductor circuit includes a plurality of first conductive layers (22), a pillar (MP), and a second conductive layer (SL), the first conductive layers being arranged in a vertical direction to the first semiconductor substrate, the pillar extending in the vertical direction and having a portion intersecting the first conductive layers, the second conductive layer being provided between the thermal diffusion layer and the first conductive layers,
the portion intersecting the pillar and the first conductive layers functions as a memory cell (MT), and
the pillar includes a semiconductor layer (41) coupled to the second conductive layer via a side surface.

6. The method of claim 1, further comprising:
while forming the laser peeling film, forming a blocking layer which is distributed in a plane parallel to the front surface of the first semiconductor substrate inside the laser peeling film and has a light blocking effect for blocking the laser beam; and
after peeling the first semiconductor substrate, removing the blocking layer.

7. The method of claim 6, wherein
the blocking layer and the thermal diffusion layer are an identical layer.

8. The method of claim 6, wherein
the blocking layer includes metal, impurity-doped silicon, or a porous material of one selected from the group consisting of glass, silicon, and alumina.

9. The method of claim 1, wherein
the laser peeling film is a silicon oxide film.

10. The method of claim 1, further comprising:
before forming the laser peeling film, forming an interlayer film on the first semiconductor substrate, wherein
the interlayer film is either a semiconductor selected from the group consisting of epitaxial silicon, polycrystalline silicon, and amorphous silicon, or is a ceramic material.
